Europäisches Patentamt

European Patent Office

Office européen des brevets

(19)

(11) EP 0 772 056 B1

(12) **FASCICULE DE BREVET EUROPEEN**

(45) Date de publication et mention
de la délivrance du brevet:
**18.08.2004 Bulletin 2004/34**

(51) Int Cl.⁷: $G01R\ 31/36$

(21) Numéro de dépôt: **96202928.6**

(22) Date de dépôt: **21.10.1996**

(54) **Système de contrôle des cycles de charge-décharge d'une batterie rechargeable, et dispositif hôte muni d'une batterie intelligente**

Steuerungssystem für von Lade-/Entladezyklen einer wiederaufladbaren Batterie und zugehörige Vorrichtung mit einer intelligenten Batterie

System for controlling the charge/discharge cycles of a rechargeable battery and host device including an intelligent battery

(84) Etats contractants désignés:
**DE ES FR GB IT**

(30) Priorité: **31.10.1995 FR 9512864**

(43) Date de publication de la demande:
**07.05.1997 Bulletin 1997/19**

(73) Titulaire: **Koninklijke Philips Electronics N.V.
5621 BA Eindhoven (NL)**

(72) Inventeurs:
- **Patillon, Jean-Noel, Société Civile S.P.I.D.
75008 Paris (FR)**
- **Gerard, Olivier, Société Civile S.P.I.D.
75008 Paris (FR)**

(74) Mandataire: **Lottin, Claudine et al
Société Civile SPID,
156, Boulevard Haussmann
75008 Paris (FR)**

(56) Documents cités:
**EP-A- 0 420 530          EP-A- 0 505 333
WO-A-90/13823**

- **TENTH E.C. PHOTOVOLTAIC SOLAR ENERGY CONFERENCE. PROC. OF THE INTERNATIONAL CONFERENCE, LISBON, PORTUGAL, 8-12 APRIL 1991, pages 427-430, XP000577575 M. STOLL: "Neural networks - a proper approach to the energy management problem?"**
- **IBM TECHNICAL DISCLOSURE BULLETIN, vol. 29, no. 1, Juin 1986, NEW YORK, US, pages 352-356, XP002008839 ANONYMOUS: "Dynamic Rechargeable Battery End-Of-Life Prediction"**

EP 0 772 056 B1

Printed by Jouve, 75001 PARIS (FR)

**Description**

L'invention concerne un système de contrôle des cycles de décharge-charge d'une batterie rechargeable, pour former une batterie intelligente. L'invention concerne également un dispositif hôte équipe dune batterie intelligente.

L'invention trouve son application dans le domaine des appareils modulaires équipés dune batterie rechargeable tels que par exemple: les téléphones cellulaires individuels ou professionnels, les outils sans fil, les ordinateurs portables, les jouets....

Par batterie intelligente, on entend généralement une batterie rechargeable, couplée à un système qui contrôle sa quantité de charge. Ce système comporte des moyens pour collecter des données sur la quantité de charge de la batterie, et des moyens pour fournir des informations prédictives calculées concernant les conditions de décharge dans le futur.

Un problème technique posé par la détermination d'informations prédictives sur les conditions de décharge dans le futur, pour une batterie rechargeable, tient à la variabilité des paramètres de construction de la batterie et à la variabilité des habitudes de l'utilisateur du dispositif hôte.

La variabilité des paramètres de construction de la batterie considérée individuellement est due à la dispersion des données de structure en cours de fabrication, pour un même type de batterie.

La variabilité des habitudes de l'utilisateur conduit à des abus qui peuvent endommager la batterie et affecter les possibilités ultérieures de recharge. Ces habitudes abusives comprennent des charges durant un laps de temps trop long, ou des recharges trop fréquentes d'une batterie non substantiellement déchargée.

Un autre problème technique tient aussi au fait que les applications actuelles des batteries rechargeables requièrent une très haute précision portant sur la quantité d'énergie disponible à un moment donné.

Un appareil et une méthode pour prédire la décharge d'une batterie sont déjà connus du brevet EP 0 420 530. Ce document décrit une technique pour prédire la réserve de temps restant avant qu'une batterie ne soit déchargée. Cette technique est basée sur un algorithme d'état de charge adaptatif qui est actif en temps réel pour répondre aux changements de conditions de la batterie. Cet algorithme est basé sur des caractéristiques de décharge mesurées de la batterie dont la réserve de temps doit être prédite. Le nombre des caractéristiques est réduit à deux paramètres déterminés à partir d'une seule courbe avec une région linéaire et une région exponentielle. Ces caractéristiques de décharge sont combinées avec des paramètres dynamiques du système de batterie contrôlés et calculés en temps réel afin de produire une évaluation continuelle et une ré-évaluation de la réserve de temps restant sous des conditions changeantes. Au cours de la décharge, il y a une continuelle amélioration de la prédiction de réserve de temps restant.

Un système de contrôle de la quantité de charge d'une batterie, utilisant un réseau de neurones est déjà connu de la publication intitulée "Neural Network, A proper Approach to the Energy Management Problem", par Marcus STOLL dans "10th European Photovoltaic Solar Energy conference", 8-I 0 APRIL 1991, LISBON, PORTUGAL, p. 427-430". La publication citée décrit l'utilisation d'un réseau de neurones pour assumer la tâche d'estimer la quantité de charge (SOC) d'une batterie plomb-acide, dans un système de recharge (RES). Selon le document cité, la détermination de la quantité de charge (SOC) est une tâche importante devant être effectuée pour contrôler le niveau d'énergie d'une batterie. En particulier, l'estimation de la quantité de charge permet la planification de l'utilisation de l'énergie renouvelable, l'optimisation des conditions d'utilisation d'un dispositif h&e, la prise de décisions qui concerne les différentes phases des cycles de décharge-charge de la batterie.

Un réseau de neurones est entraîné, au moyen d'une base de données, à estimer la quantité de charge (SOC). Pour réduire le coût, le réseau de neurones est entraîné sur seulement une petite partie du domaine de décharge de la batterie. Comme, durant la plus grande partie du temps, le courant de décharge est très petit, l'entraînement du réseau de neurones est réalisé dans ce domaine.

Dans la phase d'apprentissage du réseau de neurones, on utilise une base de données incluant le courant de décharge, la tension de décharge, et la quantité de charge sous conditions standards d'utilisation, c'est-à-dire à température fixe de 20°C, et à courant fixe. En addition, cette base de données peut inclure des informations relatives aux cycles de décharge et profondeur de décharge et à la température moyenne de la batterie. Différents lots de ces données, formant des vecteurs d'entrée, sont fournis au réseau de neurones pour lui apprendre le comportement de décharge des batteries. Le réseau de neurones s'organise pour une représentation appropriée du comportement de la batterie.

Dans la phase de classification du réseau de neurones, on lui fournit seulement le courant et la tension de décharge et il répond en sortie avec la quantité de charge correspondante de la batterie.

Un problème qui résulte de l'utilisation du système connu est que ce système n'est pas en mesure de prédire directement le laps de temps restant avant qu'un seuil critique de tension de décharge ne soit atteint.

Un autre problème qui résulte de l'utilisation du système connu est que les données correspondant au nombre de cycles antérieurs de charges-décharges et à la profondeur des décharges dans ces cycles, ne peuvent pas correctement être prises en compte. En effet, ces données sont éminemment variables en fonction de l'utilisation réelle qui est faite de la batterie en fonctionnement, et influent grandement sur la quantité de charge réelle présente dans la batterie à un instant donné d'un cycle de décharge, alors que, dans le système connu du document cité, les poids du réseau de neurones sont fixés définitivement dès la fin de la phase d'apprentissage.

Un but de la présente invention est de fournir un système de contrôle des cycles de décharge-charge d'une batterie qui fournit des informations prédictives concernant l'instant où un seuil critique prédéterminé de tension de décharge de la batterie sera atteint, et plus particulièrement des informations prédictives concernant le laps de temps restant à courir à partir de chaque instant courant d'utilisation jusqu'à l'instant où ce seuil critique prédéterminé de tension de décharge sera atteint.

Un but de la présente invention est de fournir un système de contrôle des cycles de décharge-charge d'une batterie qui fournit de telles informations prédictives qui s'adaptent automatiquement aux nouvelles données de tension qui varient à chaque phase de décharge de la batterie en fonction du nombre de cycles de décharge-charge déjà effectué antérieurement.

Un but de la présente invention est de fournir un tel système de contrôle qui fournit de telles informations prédictives qui s'adaptent aux nouvelles données réelles de tension qui varient à chaque phase de décharge de la batterie, par rapport aux données de tension prédites, du fait de la dispersion du comportement de chaque batterie individuelle par rapport à un comportement moyen.

Ces problèmes sont résolus, tel que récité dans la Revendication 1, par un système de contrôle des cycles de décharge-charge d'une batterie rechargeable, couplé à une batterie rechargeable ayant des phases de décharge alternant avec des phases de charge selon des cycles de décharge-charge, ce système comprenant :

des premiers moyens de calcul adaptatifs qui sont arrangés pour collecter, au commencement d'une phase de décharge d'un cycle de décharge-charge de la batterie, un lot de paramètres de fonctionnement appelés premiers paramètres, et pour recevoir en entrée une valeur prédéterminée d'un seuil critique de tension de décharge, et qui sont arrangés pour fournir en sortie une indication prédictive calculée de l'instant où la batterie atteindra ce seuil critique correspondant à la fin de cette phase de décharge, ce système comprenant aussi :
des seconds et des troisièmes moyens de calcul adaptatifs, couplés aux premiers moyens de calcul, qui sont arrangés pour recevoir, en entrée, à un instant initial, au commencement de ladite phase de décharge de la batterie, une valeur de la tension de batterie appelée tension initiale, une valeur d'une variation de cette tension initiale après un court laps de temps à partir de cet instant initial, et une valeur du nombre initial de cycles de décharge-charge de cette batterie, effectués antérieurement à ladite phase de décharge, et qui sont arrangés pour fournir en sortie, dès l'instant de ladite phase de décharge où les valeurs initiales sont disponibles, respectivement, un lot de paramètres approximatifs et un lot de paramètres correspondants de correction, qui sont additionnés pour fournir lesdits premiers paramètres de fonctionnement imposés aux dits premiers moyens de calcul; et un calculateur (160) applicable aux dits paramètres.

Ces problèmes sont en particulier résolus, tel que récité dans la Revendication 2, par un système tel que défini précédemment comprenant aussi :

une zone de mémoire vive pour enregistrer durant ladite phase de décharge, des lots de valeurs réelles instantanées formés chacun d'une mesure de la tension de décharge de la batterie et de l'instant courant correspondant à cette mesure,
le système de contrôle étant arrangé en sorte que, durant la phase de charge de la batterie qui suit ladite phase de décharge du cycle de décharge-charge concerné:
les premiers moyens de calcul sont en outre arrangés pour calculer A POSTERIORI de manière autonome et fournir des paramètres appelés paramètres réels qui correspondent au fonctionnement de ces premiers moyens de calcul dans la situation ou les lots de valeurs réelles instantanées leurs sont imposés, avec la mesure de tension de décharge imposée en entrée et l'instant courant correspondant imposé en sortie, le calculateur est arrangé pour recevoir lesdits paramètres approximatifs calculés par les seconds moyens de calcul durant la phase de décharge, et lesdits paramètres réels calculés par les premiers moyens de calcul durant la phase de charge, et pour fournir des différences respectives entre ces paramètres, appelées paramètres d'erreurs,
et les troisièmes moyens de calcul sont arrangés pour calculer de manière autonome des paramètres appelés paramètres adaptatifs qui correspondent au fonctionnement de ces troisièmes moyens de calcul dans la situation où les paramètres d'erreurs leur sont imposés en sortie, alors que les valeurs initiales de la phase de décharge antérieure leur sont imposées en entrée,
et système dans lequel, les troisièmes moyens de calcul conservent comme paramètres de fonctionnement, dans la phase de décharge ultérieure du cycle de décharge-charge suivant, les paramètres adaptatifs, calculés dans ladite phase de charge.

Dans un mode de réalisation particulier, tel que récité dans la Revendication 3, ces problèmes sont résolus par un système de contrôle tel que défini précédemment, dans lequel :

les premier, second et troisième moyens de calcul sont constitués respectivement par un premier, second et troisième réseaux de neurones, les premiers paramètres de fonctionnement sont les coefficients synaptiques du premier réseau de neurones, le premier réseau de neurone ayant une cellule d'entrée pour une valeur de tension, et une cellule de sortie pour une valeur de temps, le second réseau de neurone ayant trois cellules d'entrée pour lesdites valeurs initiales et un nombre de cellules de sortie pour les paramètres approximatifs en nombre égal au nombre des coefficients synaptiques du premier réseau de neurones, et le troisième réseau de neurones ayant trois cellules d'entrée pour lesdites valeurs initiales et un nombre de cellules de sortie pour les paramètres de correction en nombre égal au nombre des coefficients synaptiques du premier réseau de neurones, et dans lequel : le calculateur est arrangé, dans la phase de décharge, pour recevoir et additionner les paramètres approximatifs et les paramètres de correction et pour fournir lesdits coefficients synaptiques imposés au premier réseau de neurones.

Dans un autre mode de réalisation particulier, ces problèmes sont résolus, tel que récité dans la Revendication 4, par un système de contrôle tel que défini précédemment, dans lequel le premier réseau de neurones réalisant les premiers moyens de calcul, est arrangé pour calculer, durant la phase de charge qui suit la phase de décharge du cycle de décharge-charge concernée par une méthode de rétropropagation, des paramètres réels qui sont ses propres coefficients synaptiques réels dans la situation où, pour chaque lot de valeurs réelles instantanées, la mesure de tension de décharge est imposée à son entrée, et l'instant courant correspondant est imposé à sa sortie, le calculateur est arrangé pour fournir les paramètres d'erreurs formés par les différences respectives entre lesdits coefficients synaptiques réels calculés par le premier réseau de neurones durant ladite phase de charge, et lesdits paramètres approximatifs calculés par le second réseau de neurones pour ladite phase de décharge antérieure,

le troisième réseau de neurones réalisant les troisièmes moyens de calcul, est arrangé pour calculer, par une méthode de rétropropagation, des paramètres adaptatifs qui sont ses propres coefficients synaptiques adaptatifs, dans la situation où les paramètres d'erreurs sont imposés à ses sorties et les valeurs initiales de la phase de décharge antérieure sont imposées à ses entrées, ce troisième réseau de neurones conservant, dans la phase de décharge ultérieure du cycle de décharge-charge suivant, ces coefficients synaptiques adaptatifs, calculés dans ladite phase de charge.

L'avantage de ce système de contrôle dans l'un et l'autre de ses modes de réalisation est que les indications prédictives s'adaptent aux caractéristiques individuelles de décharge-charge de la batterie à laquelle ce système de contrôle est couplé, soit pour un type de batterie donné, soit pour différents types de batteries, car ce système de contrôle présente l'avantage d'être adaptatif à tout nouveau cycle de décharge-charge.

Un autre avantage est que ces indications prédictives sont très précises et très fiables.

Un autre avantage est que ces indications portent sur une mesure permettant à l'utilisateur de faire fonctionner un dispositif hôte muni de cette batterie "intelligente" dans les meilleures conditions d'utilisation.

Dans un mode d'application de l'invention, tel que récité dans la Revendication 13, un dispositif hôte comprend un tel système de contrôle, ce dispositif hôte étant alimenté par la batterie rechargeable qui est couplée au dit système de contrôle.

L'avantage de ce système est d'être simple à mettre en oeuvre. Le dispositif hôte couplé à ce système est particulièrement performant.

L' invention est décrite ci-après en détail en référence avec les figures schématiques annexées, dont :

la FIG.1A qui représente un système de contrôle pour batterie rechargeable, pour constituer un système global appelé batterie intelligente, en fonctionnement dans une phase de décharge d'un cycle de décharge-charge; et la FIG.1B qui représente le même système de contrôle en apprentissage dans une phase consécutive de charge, pour acquérir une fonction d'adaptativité;
la FIG.2A qui représente un premier réseau de neurones NN1,
la FIG.2B qui représente un second réseau de neurones NN2 et la
FIG.2C qui représente un troisième réseau de neurones pour ce système de contrôle;
la FIG.3 qui représente un diagramme de blocs symbolisant les étapes de la procédure d'apprentissage des trois réseaux de neurones du système de contrôle dans la phase de charge consécutive a la phase de décharge, pour acquérir une fonction d'adaptativité ;
la FIG.4A qui représente une courbe de la tension de décharge dune batterie en fonction du temps;
la FIG.4B qui représente une courbe du temps de décharge d'une batterie en fonction de la tension de décharge;
la FIG.4C qui représente des courbes de temps de décharge d'une batterie en fonction du nombre de cycles de décharge-charge, en α sans les troisièmes moyens de calculs adaptatifs, en β avec les troisièmes moyens de calculs prédictifs et adaptatifs, et en γ des valeurs réelles mesurées;
la FIG.5A qui représente les éléments pour mettre en oeuvre un système de contrôle ; et la FIG.5B qui représente un système de contrôle dans un système hôte;
la FIG.6A qui représente la structure d'une cellule neuronale de la couche cachée du premier réseau de neurones NN1 du système de contrôle, la FIG.6B qui représente la structure de la cellule neuronale de sortie de ce même premier réseau NN1.

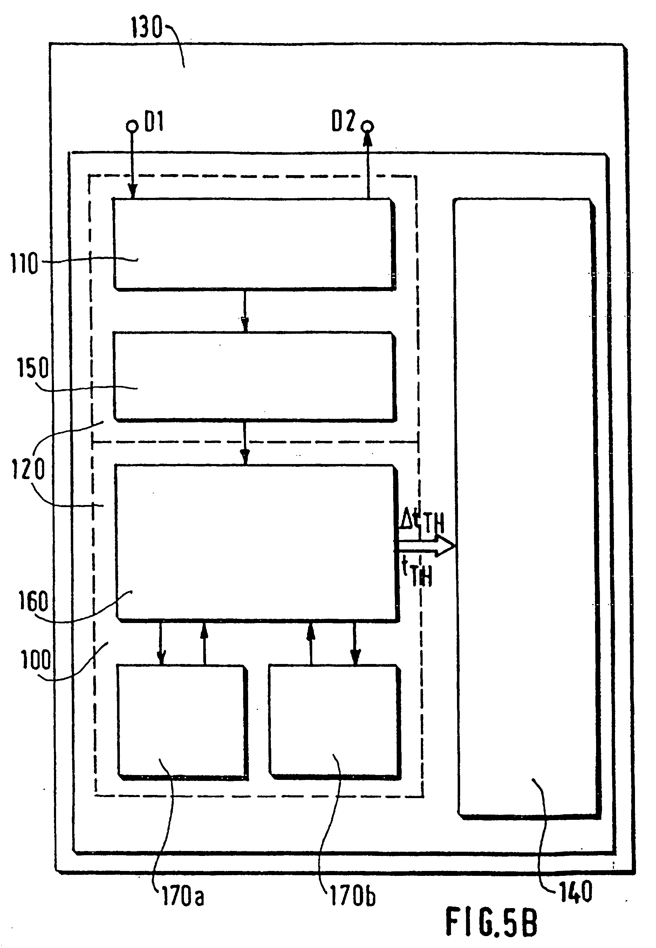

En référence avec la FIG.5B dont la légende est au Tableau II, un système de contrôle 100 est couplé à une batterie rechargeable 110, pour constituer un système global appelé batterie intelligente 120. Cette batterie rechargeable a des phases de charge alternant avec des phases de décharge selon des cycles de décharge-charge consécutifs. Le système 100 contrôle les phases de décharge et éventuellement de charge des cycles de décharge-charge de la batterie rechargeable. Ce système de contrôle 100 comprend un calculateur 160 pour fournir une indication d'un instant $t_{TH}$ où, dans une phase de décharge, la batterie 110 atteindra un seuil critique prédéterminé de tension $V_{TH}$ et plus spécifiquement, pour fournir une indication du laps de temps $\Delta T_{TH}$ restant a courir, avant que ce seuil critique prédéterminé de tension de décharge $V_{TH}$ ne soit atteint, ou bien les deux indications.

L'ensemble de cette batterie intelligente 120 peut être incorporée dans, ou couplée à ce dispositif hôte 130. Dans ce cas, cette batterie rechargeable 110 est couplée par des connexions D1, D2 à ce dispositif hôte 130. Le dispositif hôte comprend en outre des moyens d'affichage 140, pour fournir à l'utilisateur les indications de temps $t_{TH}$ ou $\Delta_{TH}$, ou les deux.

Le système de contrôle 100 est aussi couplé à des moyens de mesure 150 du temps, et de la tension de batterie.

Procédure de fonctionnement du système de contrôle 100 durant une phase de décharge, d'un cycle de décharge-charge

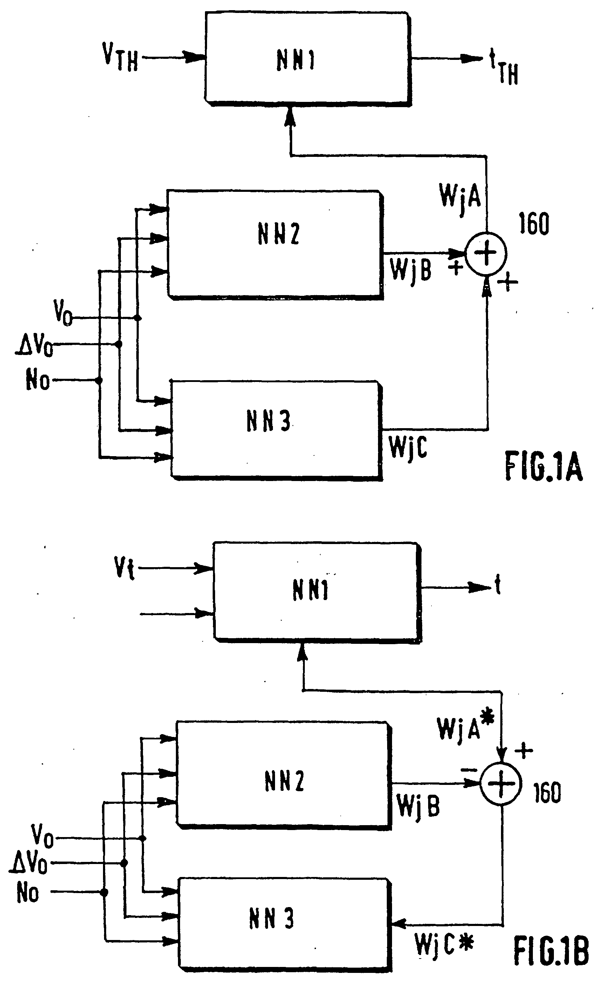

En référence avec la FIG.1A, qui représente le système de contrôle fonctionnant dans une phase de décharge de la batterie, ce système de contrôle 100 collecte d'une part des valeurs appelées initiales, à un instant appelé instant initial to, qui coïncide avec le tout début d'une phase de décharge de la batterie dans un cycle de décharge-charge. Ces valeurs initiales sont :

Vo la tension de la batterie, Vo étant alors appelée tension initiale de la batterie à cet instant initial to ;
ΔVo la variation de la tension de batterie encore appelée variation de tension initiale, mesurée au cours d'un premier laps de temps Δto très court d'utilisation de la batterie entre l'instant initial to et un instant ultérieur t'o = to+Δto ;
No le nombre de cycles de décharge-charge de la batterie déjà effectué avant l'instant initial considéré to; No peut éventuellement être égal à 0 ( zéro ) si le cycle considéré est le premier cycle d'utilisation de la batterie, antérieurement neuve et n'ayant jamais été rechargée ; No est appelé nombre de cycle initial.

Ce système 100 peut collecter d'autre part des valeurs instantanées à chaque instant courant successif t de cette même phase de décharge. Ces valeurs instantanées sont :

Vt la tension de la batterie à un instant courant t et l'instant t correspondant.

En référence avec la FIG.1A, un système 100 de contrôle des cycles de décharge-charge d'une batterie rechargeable 110 comprend des premier, second et troisième moyens de calcul prédictifs et adaptatifs couplés notés respectivement NN1, NN2, et NN3, pour fournir, à partir des valeur initiales de tension Vo, ΔVo, No mesurées dans une phase de décharge, et à partir de la valeur fixée d'un seuil de tension critique $V_{TH}$, l'indication prédictive d'un instant appelé instant critique $t_{TH}$ où, dans la même phase de décharge, la tension de batterie atteindra ce seuil critique $V_{TH}$, et plus spécifiquement, une indication prédictive du laps de temps $\Delta t_{TH}$ restant à courir avant que ce seuil critique de tension de décharge $V_{TH}$ ne soit atteint, ce seuil étant prédéterminé pour que, avant que la tension de batterie n'atteigne ce seuil $V_{TH}$, la batterie 110 conserve une énergie de fonctionnement précisément connue, et située dans une certaine fourchette où cette énergie est correctement adaptée au fonctionnement d'un dispositif hôte 130 qu'elle alimente.

Tel que représenté sur la FIG.1A, dans un mode de réalisation, les premier, second et troisième moyens de calcul prédictifs et adaptatifs du système de contrôle 100 sont respectivement constitués par un premier réseau de neurones référencé NN1, un second réseau de neurones référencé NN2 monté en série avec le premier réseau de neurones NN1, et un troisième réseau de neurones NN3 monté en parallèle sur le deuxième réseau de neurones.

Dans la description ci-après, une première phase de décharge, notée PD1, commençant à un instant to dans un cycle de décharge-charge, est d'abord considérée ; et un seuil critique prédéterminé de tension de décharge $V_{TH}$ est fixé.

Le premier réseau de neurones NN1 a une entrée pour :

la tension $V_{TH}$ qui constitue le seuil critique prédéterminé, et a une sortie pour fournir à chaque instant courant t, par exemple toutes les minutes :
l'instant $t_{TH}$ où ce seuil critique prédéterminé de tension $V_{TH}$ est atteint.

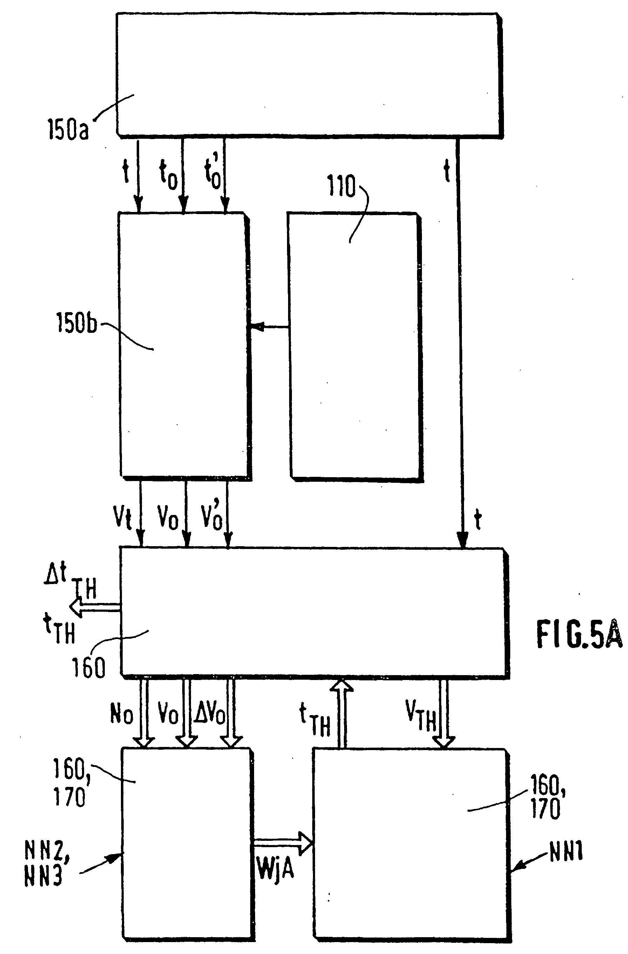

En référence avec la FIG.5A dont la légende est au Tableau I, le premier réseau de neurones NN1 est couplé à des moyens de mesure du temps 150a, qui fournissent une mesure de chaque instant courant t, et est couplé au calculateur 160 qui a une fonction d'additionneur et qui fournit par différence entre l'instant courant t et la valeur calculée de l'instant $t_{TH}$ :

une valeur $\Delta t_{TH}$ du laps de temps restant à courir avant que le seuil critique prédéterminé de tension de décharge $V_{TH}$ ne soit atteint, dans le cas où la batterie est en fonctionnement normal pour alimenter un système hôte 130, et se décharge normalement du fait de ce fonctionnement.

Dans ce mode de réalisation exemplatif, les coefficients synaptiques ou poids de ce premier réseau de neurones NN1 sont au nombre de 13 et sont référencée WjA où "j" est un indice de 1 à 13. Ils sont appelés premier paramètres WjA et sont calculés et fournis automatiquement durant cette première phase de décharge PD1, par le second réseau de neurones NN2 coopérant avec le troisième réseau de neurones NN3.

Le second réseau de neurones NN2 a 3 entrées pour :

Vo la tension initiale mesurée à l'instant initial to de cette première phase de décharge PD1,
$\Delta$Vo la variation de tension initiale, à un instant to' repéré après un court laps de temps $\Delta$to, en partant de l'instant initial to, par exemple 1 minute,
No le nombre initial de cycles,

et a 13 sorties pour 13 paramètres WjB appelés paramètres approximatifs, qui participent à constituer les coefficients synaptiques ou poids WjA du premier réseau de neurones NN1.

Le troisième réseau de neurones NN3 a les mêmes entrées que le second réseau de neurones NN2, c'est-à-dire à trois entrées pour :

Vo la tension initiale mesurée à l'instant initial to de cette première phase de décharge PD1,
$\Delta$Vo la variation de tension initiale, à un instant t'o repéré après un court laps de temps $\Delta$to, en partant de l'instant initial to, par exemple 1 minute,
No le nombre initial de cycles,

et a 13 sorties pour 13 paramètres de correction WjC pour corriger respectivement les 13 paramètres approximatifs WjB issus du second réseau de neurones NN2.

Le calculateur 160, qui a une fonction d'additionneur, fournit, entre autres, la valeur de la variation initiale de tension $\Delta$to en calculant la différence entre la tension initiale Vo mesurée à l'instant to, et une tension ultérieure V'o à l'instant suivant t'o, telle que $\Delta$Vo = Vo - V'o.

Ce calculateur 160 fournit en outre, dans sa fonction d'additionneur, les coefficients synaptiques ou poids WjA nécessaires au fonctionnement du premier réseau de neurone durant cette première phase de décharge PD1, en effectuant l'addition des paramètres approximatifs WjB issus du second réseau de neurones et des paramètres de correction WjC issus du troisième réseau de neurones.

Les 13 résultats respectifs WjA = WjB + WjC sont imposés au premier réseau de neurones pendant cette première phase de décharge PD1, comme premiers paramètres de fonctionnement.

En référence avec la FIG.5B dont la légende est au Tableau II, le système de contrôle comprend en outre des zones de mémoire vive RAM 170b pour enregistrer ou fournir selon le cas, les mesures variables et les poids du premier et du troisième réseau de neurones, et une zone de mémoire morte ROM 170a pour stocker les données de structures des réseaux de neurones NN1, NN2 et NN3, les paramètres fixes et les poids du second réseau de neurones NN2.

Ces mémoires sont accessibles par le calculateur 160, lequel effectue les calculs nécessaires au fonctionnement du système de contrôle 100.

Chacun des réseaux de neurones NN1, NN2 et NN3 doivent être organisés (ou arrangés) pour mener à bien ces calculs et fournir ces sorties. A cet effet, chacun d'eux est soumis à une procédure d'apprentissage et à une procédure de test appelées phases d'entraînement pendant lesquelles leurs coefficients synaptiques sont déterminés et, dans certains cas, fixés.

Procédure d'apprentissage des réseaux de neurones.

La tâche du premier réseau de neurones NN1 est d'apprendre des modèles de courbes de décharge. Cet apprentissage permet de construire une relation entre la valeur instantanée de la tension de décharge de batterie notée Vt, et l'instant courant t où la batterie atteint cette tension Vt. Le premier réseau de neurones NN1 doit, lors de son apprentissage, construire des fonctions Fw qui résolvent la relation (1a) :

$$t = Fw(Vt) \qquad\qquad (1a)$$

où l'indice w affecté à F symbolise le fait que la fonction F est liée aux poids WjA, ou coefficients synaptiques, du premier réseau de neurones NN1.

Le réseau de neurones NN1 a été construit pour générer une fonction Fw non linéaire.

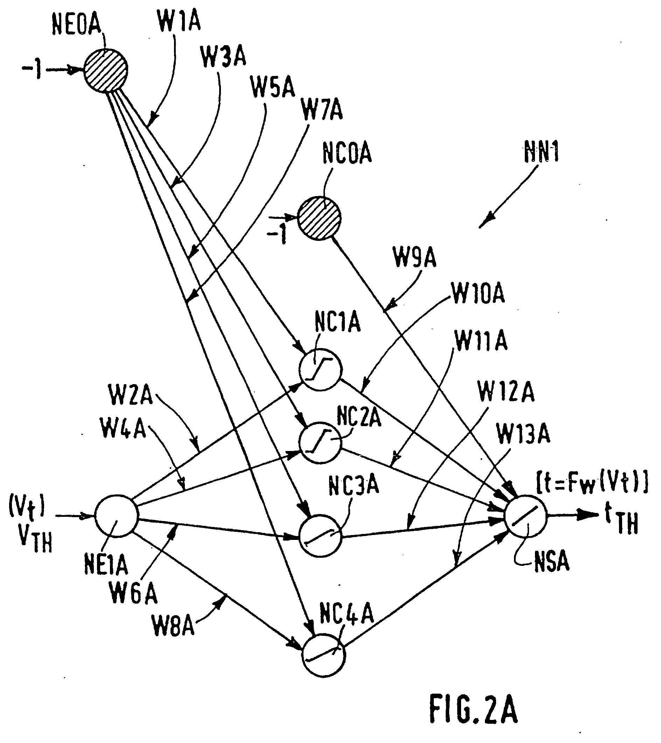

En référence avec la FIG.2A, le premier réseau de neurones NN1 comprend :

une couche d'entrée formée de 2 cellules neuronales, incluant une première cellule neuronale NE0A pour l'entrée d'une valeur de seuil choisie à -1, et une seconde cellule neuronale NE1A pour l'entrée de la valeur instantanée. de tension Vt à l'instant t,
une couche cachée de 5 cellules neuronales, incluant une première cellule neuronale cachée NCOA pour l'entrée d'une valeur de seuil choisie à -1, et quatre cellules neuronales cachées notées NC1A à NC4A,
et une couche de sortie ayant une cellule neuronale unique notée NSA.

Donc, on remarque que, durant la procédure d'apprentissage du premier réseau de neurones NN1, son entrée NE1A collecte une valeur de tension instantanée Vt, alors que cette même entrée collecte la valeur de seuil critique de tension $V_{TH}$ lors de l'usage courant.

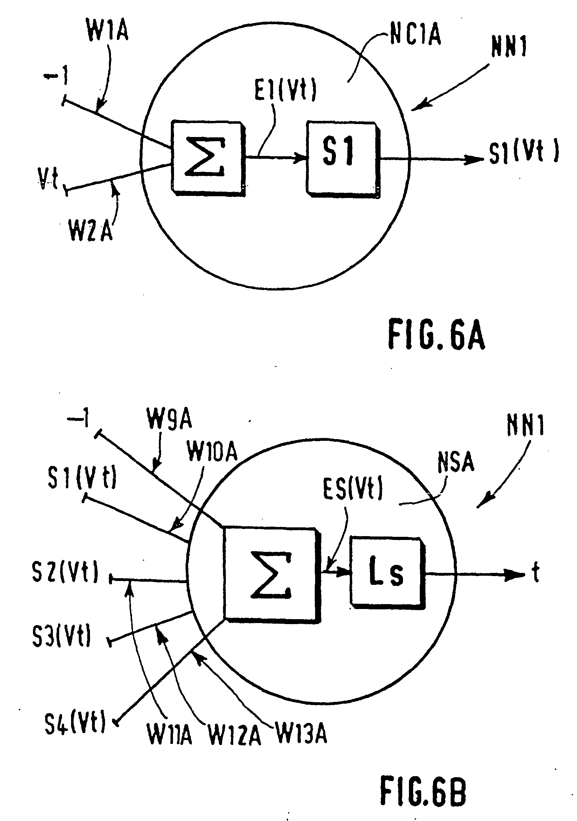

La structure et l'équation de fonctionnement de chaque neurone caché, noté NC1A à NC4A, sont celles d'un neurone formel "standard", et sont illustrées par la FIG.6A, qui montre la cellule cachée NC1A, à titre d'exemple.

Chaque neurone caché donné NCiA reçoit d'une part en entrée la tension instantanée Vt avec un poids, ou coefficient synaptique d'entrée, qui est l'un des 13 poids référencé WjA, et reçoit d'autre part un seuil ayant pour valeur la constante "-1", affecté d'un autre des 13 poids référencé WjA. L'indice "i" est l'indice 1 à 4 de la cellule neuronale cachée NC1A à NC4A concernée. Chaque neurone caché NCiA réalise une somme pondérée, notée $\Sigma$, des entrées affectées d'un des poids WjA, et calcule une sortie intermédiaire Ei(Vt).

Chaque neurone caché NC1A à NC4A transfère cette sortie intermédiaire Ei(Vt), à travers une fonction d'activation notée Si, et il calcule une sortie notée Si(Vt) selon la relation (2a) :

$$Si\,(Vt) = Si[Ei(Vt)] \qquad\qquad (2a)$$

Il reste alors à mieux définir la fonction d'activation Si(Vt) de chaque neurone caché. On peut adopter comme fonction d'activation possible, une fonction choisie dans l'ensemble des fonctions non linéaires.

La fonction d'activation Si est de préférence une fonction sigmoïde "tanh" égale à la fonction tangente hyperbolique, qui est très bien adaptée à la forme des courbes de décharge à construire, comme on le montrera ultérieurement. Dans la couche cachée, les 4 cellules neuronales NC1A à NC4A montrent donc dans l'exemple décrit, une fonction non linéaire "tanh".

La structure de l'unique neurone de sortie NSA est illustrée par la FIG.6B. Il réalise une somme pondérée, notée $\Sigma$, des sorties Si(Vt) de tous les neurones cachés NCiA, en utilisant des coefficients synaptiques WjA, somme à laquelle s'ajoute la valeur d'un seuil "-1" provenant de la cellule cachée NCOA, cette valeur de seuil étant introduite dans le neurone de sortie NSA à travers l'un des coefficients synaptiques WjA.

Ce neurone de sortie effectue donc d'abord la somme pondérée $\Sigma$ qui donne une sortie intermédiaire Es(Vt).

Puis, le neurone de sortie NSA transfère cette sortie intermédiaire Es(Vt), à travers une fonction d'activation notée Ls, et il calcule une sortie finale notée Fw(Vt) selon la , relation (3a) :

$$Fw(Vt) = Ls[Es(Vt)] \qquad\qquad (3a)$$

La fonction d'activation Ls de ce neurone de sortie est choisie linéaire. La sortie du neurone de sortie est la fonction Fw que l'on cherche à générer.

Les notations des poids de chaque neurone caché NCiA sont indiqués sur la FIG.2A, ainsi que les notations des poids d'entrée du neurone de sortie NSA. L'ensemble de ces poids notés W1A à W13A est formé par l'ensemble des 13 poids WjA transmis par les second et troisième réseaux de neurones NN2 et NN3 montés en parallèle dont les sorties sont couplées par le calculateur 160 à fonction d'additionneur.

En référence avec la FIG.4A, une courbe conventionnelle de décharge d'une batterie cadmium-nickel prise à titre d'exemple, donne la tension instantanée Vt en volt en fonction du temps t en minutes. Cette courbe montre une forte pente dans la première période de fonctionnement de la batterie, par exemple les 100 premières minutes, puis une pente faible entre 100 et 500 minutes d'utilisation, et enfin à nouveau une forte pente au-delà de 500 minutes. Bien entendu, cette courbe de décharge est donnée tout à fait à titre d'exemple.

Mais, dans le présent système, on rappelle que le premier réseau de neurones NN1 doit subir un apprentissage conduisant à fournir un temps t qui est une fonction Fw de la tension Vt de la batterie.

C'est pourquoi, un exemple de courbe de décharge qui intéresse la présente description est représenté sur la FIG.4B. Cette courbe montre le temps t en fonction de la tension de batterie Vt. Cette courbe de la FIG.4B est tracée simplement en portant les valeurs qui étaient en abscisse sur la FIG.4A, en ordonnée sur la FIG.4B ; et en portant les valeurs qui étaient en ordonnée sur la FIG.4A en abscisse sur la FIG.4B . On peut constater que cette courbe de décharge a une forme approchant la forme d'une courbe "tanh". C'est pourquoi, les fonctions du type des sigmoïdes sont préférées pour réaliser les fonctions d'activation dans les neurones de la couche cachée.

La FIG.4B fournit donc une courbe de décharge donnant le temps t en minutes en fonction de la tension Vt en volt qui montre des parties extrêmes quasiment planes et une partie intermédiaire ayant une pente abrupte. C'est pourquoi, dans le premier réseau de neurones NN1, la modélisation de la partie intermédiaire des courbes de décharge de la relation (1a) est effectuée par les deux premières cellules neuronales NC1A, NC2A de la couche cachée, dont les fonctions d'activation ont respectivement une pente forte ; alors que la modélisation des parties extrêmes de ces courbes est effectuée par les cellules neuronales cachées suivantes NC3A, NC4A, qui montrent une fonction d'activation à pente moins forte.

La présence de cellules cachées ayant des fonctions d'activation montrant des pentes très nettement différentes revient à spécialiser chaque cellule cachée dans la réalisation de taches différentes prédéterminées. Il est clair que le réseau de neurones NN1 pourrait apprendre la tâche de fournir la fonction Fw avec le même niveau de performance, sans que cette spécialisation existe. Mais, selon l'invention, il a été trouvé que la phase d'apprentissage du réseau de neurones NN1 se trouve considérablement raccourcie du fait que chaque cellule est dédiée à une tâche prédéterminée.

Les pentes des fonctions d'activation Si des cellules cachées NC1A, NC2A peuvent être par exemple 7.0, et les pentes de fonctions d'activation des cellules cachées suivantes NC2A, NC4A peuvent être par exemple 2.0.

Pour l'apprentissage du premier réseau de neurones NN1, des courbes de temps t de décharge en fonction de la tension V(t) de décharge sont enregistrées par exemple toutes les minutes pour un grand nombre N de cycles de décharge, et pour un grand nombre de batteries 110 du même type, par exemple des batteries cadmium-nickel.

Dans un exemple, 20 batteries sont utilisées, et subissent 140 cycles de décharge-charge. Une batterie est considérée comme totalement chargée quand sa tension Vo est de 9V, et est considérée comme ayant atteint le seuil critique de décharge quand sa tension atteint $V_{TH}$ = 6V. Par cette méthode, 20 x 140 = 2800 courbes de décharge sont enregistrées, de telle manière que chaque courbe fournit 1600 points.

Chaque courbe est enseignée à un réseau NN1 différent. Ainsi dans la phase d'apprentissage, 2800 réseaux sont initialisés, c'est-à-dire 1 réseau par courbe. Dans chaque courbe, par exemple la moitié des points, c'est-à-dire 800 points, est utilisée pour l'apprentissage du réseau de neurone NN1 correspondant et, l'autre moitié des points, c'est-à-dire 800 autres points, est utilisée pour tester ledit réseau de neurones NN1.

A l'issue de cet entraînement comprenant la phase d'apprentissage et les tests, les 13 poids WjA de chacun des 2800 réseaux de neurones NN1 sont mémorisés dans une zone de mémoire vive RAM, référencée 170b sur la FIG.5B.

A partir de là, les valeurs des lots de 13 poids WjA en mémoire vont constituer une base de données pour l'apprentissage du second réseau de neurones NN2.

La tâche du second réseau de neurones NN2 est d'apprendre une relation entre des paramètres dépendant de la tension de décharge de la batterie. Ainsi, le second réseau de neurones NN2 reçoit :

No le nombre de cycles initial,
Vo la première tension enregistrée de la courbe de décharge concernée,
et ΔVo la pente à l'origine de cette courbe de décharge, et doit pouvoir calculer, à partir de ces mesures, les 13 poids WjA nécessaires au fonctionnement du premier réseau de neurones NN1.

Cette relation s'exprime par la fonction G de la relation (4a) :

$$WjA= G(Vo, \Delta Vo, No) \qquad\qquad (4a)$$

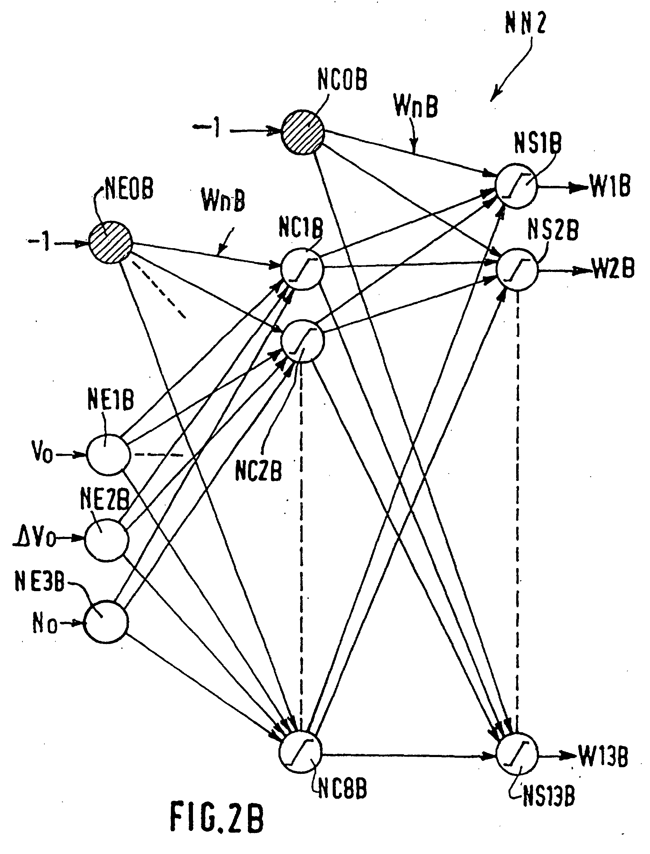

En référence avec la FIG.2B, la structure du second réseau de neurones NN2 est dictée par sa tâche. Ce réseau de neurones NN2 comprend :

une couche d'entrée avec 3 cellules d'entrée NE1B, NE2B, NE3B, pour les valeurs Vo, $\Delta$Vo et No, plus une cellule d'entrée NEC0B pour un seuil à -1 ;
13 cellules de sortie NS1B à NS13B pour respectivement chacun de 13 paramètres approximatifs WjB de valeurs voisines de la valeur recherchée des poids du premier réseau de neurones ;
une seule couche cachée avec 8 cellules neuronales cachées notées NC1B à NC8B, plus une cellule cachée NC0B pour un seuil à -1.

Selon l'invention, les entrées constituées par les valeurs initiales Vo et $\Delta$Vo ont été spécifiquement choisies parce qu'il est apparu que c'était les valeurs les plus sensibles aux caractéristiques de la batterie.

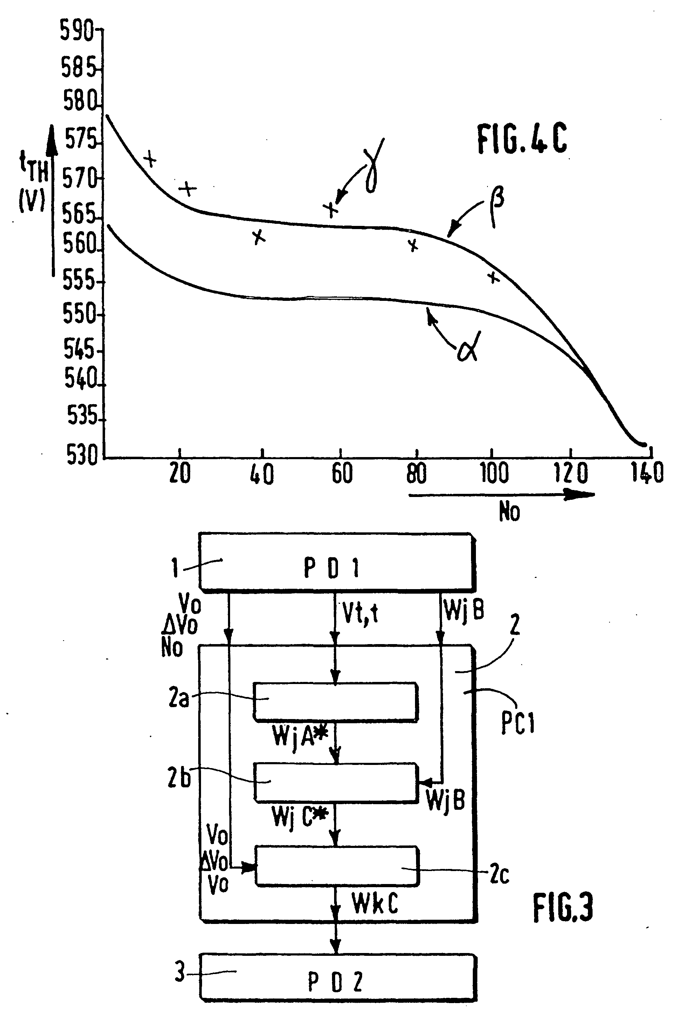

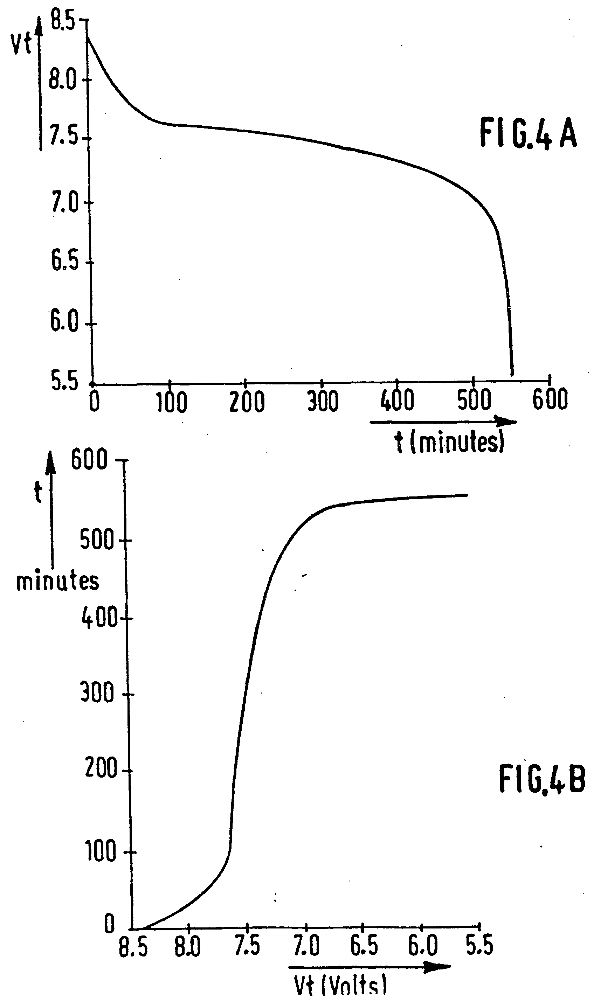

La troisième entrée constituée par le nombre initial No de cycles a été également spécifiquement choisie parce qu'elle permet de prendre en compte un effet de vieillissement de la batterie, du fait que plus une batterie a subi de cycles de décharge-charge, moins il lui reste de temps de vie, c'est-à-dire moins l'effet de la recharge est efficace et plus le temps de décharge est rapide. Cet effet de vieillissement est illustré par la FIG.4C, qui montre en $\gamma$, des points mesurés correspondant au temps de décharge $t_{TH}$ pour atteindre le seuil critique $V_{TH}$ à partir de l'instant initial to, en fonction du nombre initial de cycles No. Ces mesures $\gamma$ montrent que plus le nombre de cycles déjà effectués est grand, plus le temps de décharge $t_{TH}$ est court.

Les coefficients synaptiques ou poids, référencés WnB de ce second réseau de neurones sont fixés lors de sa phase d'apprentissage et sont mis en mémoire dans la zone de mémoire morte ROM 170a, représentée sur la FIG. 5B.

Des essais appliqués au réseau de neurones NN2 ont montré qu'un tel réseau muni de 8 cellules cachées, ayant pour fonction d'activation une fonction non linéaire tangente hyperbolique "tanh" est capable de mener à bien la tache qui lui est assignée.

Il faut noter que, à la différence de la cellule de sortie NSA du premier réseau de neurone, les cellules de sortie, notées NS1B à NS13B du second réseau de neurone NN2 ont une fonction d'activation non linéaire, de préférence "tanh".

Comme le premier réseau de neurones NN1, ce second réseau de neurones NN2 a des cellules cachées dont la pente de la fonction d'activation sigmoïde est différente d'une cellule à l'autre. Ce mode de réalisation permet de ne pas utiliser un nombre important de cellules cachées.

Ainsi, le second réseau de neurones NN2 est entraîné en utilisant 1400 vecteurs de 13 valeurs de poids générés par l'apprentissage du premier réseau de neurones NN1 au moyen des 2800 courbes enregistrées, et les 1400 autres vecteurs générés sont utilisés pour les tests.

La procédure de test est réalisée de la manière suivante : pour les 1400 vecteurs qui n'appartiennent pas au lot d'apprentissage, les valeurs initiales correspondantes Vo, $\Delta$Vo et No sont appliquées aux entrées du second réseau de neurones. Celui-ci calcule un vecteur de sortie de 13 valeurs de poids WjB comme il a été entraîné à le faire.

Poursuivant cette procédure de test, ces 13 valeurs de poids WjB sont imposées à un réseau de neurone NN1, en même temps que la valeur critique prédéterminée de tension de décharge $V_{TH}$ = 6 volts est appliquée à son entrée NE1A. Ce premier réseau de neurone NN1 calcule alors la valeur prédictive automatiquement adaptée de temps de décharge $t_{TH}$ qui est comparée à celle de la courbe de test.

En référence avec la FIG. 4C, on montre en $\alpha$, une courbe prédictive de temps de décharge en fonction du nombre de cycles No, ainsi obtenue.

Dans la phase d'apprentissage décrite plus haut, on n'a pas tenu compte de la présence du troisième réseau de neurones NN3.

En référence avec la FIG.4C, si ce troisième réseau de neurones NN3 n'est pas mis dans le circuit, la courbe a donnant l'indication prédictive du temps $t_{TH}$ de décharge en fonction du nombre de cycles No diffère d'une courbe s'appuyant sur les mesures réelles $\gamma$, c'est-à-dire que le système de contrôle fait une erreur moyenne d'environ 10 mn dans la détermination prédictive de l'instant $t_{TH}$ où la batterie atteindra le seuil de tension critique $V_{TH}$.

Il est donc important de corriger cette erreur affectant la détermination prédictive de cet instant $t_{TH}$.

Cette erreur peut être corrigée en corrigeant les poids imposés pour le fonctionnement du premier réseau de neurones. Ceci est fait en ne fournissant pas directement au premier réseau de neurones NN1 les paramètres WjB calculés par le second réseau de neurones NN2, parce qu'ils sont approximatifs et entraînent l'erreur qu'on a citée.

Ceci est donc fait en corrigeant respectivement ces paramètres approximatifs WjB par des paramètres de correction WjC, fournis par le troisième réseau de neurones NN3, et en nombre égal aux paramètres approximatifs WjB.

Pour aboutir aux meilleurs poids WjA du premier réseau de neurones NN1, les paramètres approximatifs WjB et les paramètres de correction WjC sont additionnés par le calculateur 160 dans sa fonction d'additionneur et le résultat est imposé à ce premier réseau de neurones NN1.

En référence avec la FIG.1B, dans la phase d'apprentissage, le troisième réseau de neurones NN3 apprend à calculer ses propres coefficients synaptiques, ou poids, comme des valeurs adaptatives, pour lui permettre de calculer les paramètres de corrections WjB qui, additionnés aux paramètres approximatifs WjA fournis par le second réseau de neurones NN2, vont constituer les coefficients synaptiques ou poids les mieux adaptés au fonctionnement du premier réseau de neurones NN1. Ainsi, ce premier réseau de neurones NN1 munis de ces poids WjA adaptés pourra fournir, durant la décharge, une indication prédictive de l'instant critique $t_{TH}$ plus proche de la valeur réelle.

Par exemple, avec l'utilisation de ce troisième réseau de neurones, la différence entre l'indication prédictive $\beta$ de $t_{TH}$ et la valeur mesurée $\gamma$ est abaissée à environ 1 minute comme démontré par les courbes de la FIG.4C. Cela est un grand avantage dans l'obtention de la précision des indications prédictives, puisque le système de contrôle passe d'une erreur de 10 mn sur les environs 570 mn de durée d'une décharge, à 1 mn sur ces 570 mn.

Le système de contrôle ainsi constitué devient donc d'une très grande précision.

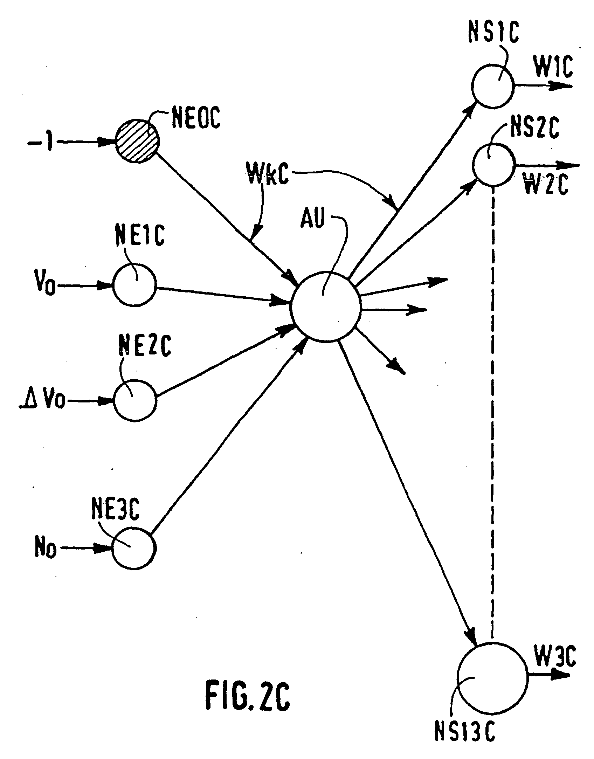

En référence avec la FIG.2C, le troisième réseau de neurones NN3 reçoit :

No le nombre de cycles initial,

Vo la première tension enregistrée de la courbe de décharge concernée,

et ΔVo la pente à l'origine de cette courbe de décharge, et doit pouvoir calculer, à partir de ces mesures, les 13 paramètres de correction WjC coopérant à fournir, avec les 13 poids approximatifs WjB, les poids WjA nécessaires au fonctionnement du premier réseau de neurones NN1.

En référence avec la FIG.2C, la structure du troisième réseau de neurones NN3 est dictée par sa tâche. Ce réseau de neurones NN3 comprend :

une couche d'entrée avec 3 cellules d'entrée NE1C, NE2C, NE3C, pour les valeurs Vo, ΔVo et No, plus une cellule d'entrée NE0C pour un seuil à -1 ;

13 cellules de sortie NS1C à NS13C pour respectivement chacun de 13 paramètres de correction WjC. Ces cellules de sortie ont des fonctions d'activation identiques à celles des cellules de sortie correspondante du second réseau de neurones NN2, c'est-à-dire des fonctions sigmoïdes "tanh" de même pente respectivement ;

une seule couche cachée avec 1 cellule neuronale cachée notée AU, sans cellule cachée pour un seuil.

Le troisième réseau de neurones nécessite, pour son fonctionnement, 4 coefficients synaptiques en entrée et 13 coefficients synaptiques en sortie, soit en tout 17 coefficients synaptiques notés WkC, où k est un indice de 1 à 17.

En référence avec la FIG.3, dont la légende est au Tableau III, qui représente un diagramme de blocs illustrant le déroulement de la procédure d'apprentissage du troisième réseau de neurones. NN3, cette procédure comprend :

1) Une première étape illustrée par le bloc 1, qui correspond à une première phase de décharge PD1 ; durant cette étape :

- le second réseau de neurones reçoit des valeurs initiales Vo, ΔVo, et No et calcule des paramètres approximatifs WjB,

- une zone de mémoire vive (RAM) 170 b enregistre des mesures instantanées fournies, en référence avec la FIG.5A par des moyens de mesure du temps 150a, et par des moyens de mesure de tension 150b de la batterie rechargeable 110 ; ces mesures instantanées sont enregistrées à chaque instant courant de ladite première phase de décharge PD1, par exemple toutes les minutes, et comprennent la mesure de l'instant courant t et de la valeur de tension correspondante Vt.

2) Une deuxième étape illustrée par le bloc 2, de la FIG.3 et par la FIG.1B, qui est menée à bien durant le temps laissé libre pour le calculateur 160 et pour les réseaux de neurones correspondant à une première phase de charge PC1 consécutive à la fin de la première phase de décharge PD1 ; durant cette étape, sont menées à bien trois sous-étape :

2a) une sous-étapes illustrée par le bloc 2a pendant laquelle :

les lots de valeurs de mesures instantanées Vt, t mesurées à chaque instant courant de la phase de décharge précédente PD1, sont imposées au premier réseau de neurones NN1, de manière telle que :

la mesure instantanée de tension Vt est imposée à l'entrée NE1A du premier réseau de neurones NN1, la mesure instantanée de l'instant correspondant t est imposée à la sortie NSA du premier réseau de neurones NN1.

Par une méthode de rétropropagation connue de l'état de l'art des réseaux de neurones, le premier réseau de neurones NN1 calcule ses 13 poids internes correspondant à ces valeurs réelles instantanées imposées. Ces 13 poids calculés sont appelés poids réels et notés WjA*. Ces poids WjA* sont les 13 meilleures valeurs possibles de paramètres de fonctionnement du premier réseau de neurones NN1 correspondant à la courbe de décharge réelle enregistrée durant la phase de décharge précédente PD1.

2b) Une sous-étape illustrée par le bloc 2b menée à bien encore durant la phase de charge PC1, pendant laquelle :

ces 13 meilleures valeurs de poids réels WjA* sont ensuite fournies au calculateur 160. Ce calculateur 160 reçoit également les 13 paramètres approximatifs WjB qui avaient été calculés par le second réseau de neurones NN2 pendant la phase de décharge précédente PD1.

Dans cette seconde sous-étape 2b, le calculateur 160, dans sa fonction d'additionneur, effectue respectivement la différence entre ces 13 valeurs de poids réels WjA* et ces 13 paramètres approximatifs WjB, de manière à calculer 13 paramètres d'erreurs notés WjC*

$$WjC* = WjA* - WjB$$

où on rappelle que j est un nombre de 1 à 13 correspondant au nombre de poids nécessaires au fonctionnement du premier réseau de neurones dans cet exemple.

2c) Une sous-étape illustrée par le bloc 2c, menée à bien toujours durant la phase de charge PC1, et pendant laquelle :

ces 13 paramètres d'erreurs WjC* sont imposés respectivement aux 13 sorties NS1C à NS13C du troisième réseau de neurones NN3, tandis que les valeurs initiales Vo, ΔVo et No utilisées lors de la phase de décharge précédente PD1 sont imposées à ses entrées NE1C à NE3C.

Ces 13 paramètres d'erreurs WjC* sont en fait les meilleures sorties possibles du troisième réseau de neurones NN3.

Par la méthode de rétropropagation connue, le troisième réseau de neurones NN3 calcule alors ses propres coefficients synaptiques adaptatifs notés WkC, qui sont stockés dans une zone de mémoire vive RAM 170b

3) Cette troisième étape correspond à un second cycle de décharge-charge commençant par une nouvelle phase de décharge notée PD2.

Dans cette nouvelle phase de décharge PD2, les coefficients synaptiques adaptatifs WkC, où k est un nombre de 1 à 17, correspondant à la structure du troisième réseau de neurones, représentée sur la FIG.2C, qui ont été calculés pendant la phase de charge PC1 du cycle précédent, sont conservés pour une nouvelle détermination des coefficients synaptiques du premier réseau de neurones NN1, comme décrit précédemment, en procédure de fonctionnement du système de contrôle.

Avec ces coefficient synaptiques adaptatifs WkC ainsi calculés, le troisième réseau de neurones NN3 fournit dans cette nouvelle phase de décharge PD2, des paramètres de correction WjC particulièrement bien adaptés à la correction des paramètres approximatifs WjB fournis par le second réseau de neurones NN2.

Le calculateur 160 effectue cette correction en réalisant l'addition WjB + WjC qui fournit des nouveaux coefficients synaptiques mieux adaptés pour le premier réseau de neurones NN1 dans cette deuxième phase de décharge.

Modes opératoires du système de contrôle de batterie rechargeable

Le système de contrôle 100 a trois modes opératoires appelés mode d'initialisation, mode d'usage courant, et mode adaptatif.

Le mode d'initialisation est mis en oeuvre chaque fois que la batterie 110 a terminé une procédure de charge d'un cycle de décharge-charge, et qu'elle commence alors un nouveau cycle commençant par une phase de décharge. Dès que la batterie 110 est mise en service, la tension initiale Vo est aussitôt enregistrée. Puis, à l'instant t'o, après qu'un très petit laps de temps to - t'o = Δto s'est écoulé, de préférence exactement 1 minute, la tension de batterie est à nouveau enregistrée donnant une valeur notée V'o, et la différence de tension initiale Vo - V'o = ΔVo est calculée, par exemple par le calculateur à fonction additionneur 160 montré sur les FIG.5A et 5B. Ensuite, les deux valeurs Vo et $\Delta$Vo, en même temps que le nombre initial No des cycles déjà effectués, nombre qui est calculé par incrémentation par le calculateur 160, sont fournis à l'entrée du second réseau de neurones NN2 qui calcule alors le vecteur de 13 valeurs de poids WjB à appliquer au premier réseau de neurones NN1A.

Le mode d'usage courant est mis en oeuvre pendant la phase de décharge elle-même. Dans ce mode d'usage courant, la tension instantanée Vt est mesurée et stockée toute les minutes pour la réactualisation ultérieure des poids du troisième réseau de neurones. Le laps de temps restant $\Delta t_{TH}$ avant que la batterie n'atteigne ce seuil critique prédéterminé de tension $V_{TH}$ = 6V est calculé comme une différence entre un temps $t_{TH}$ et un temps t,

où $t_{TH}$ est la sortie du réseau NN1A quand son entrée est mise à $V_{TH}$ = 6 V,

et où t est l'instant mesuré par les moyens de mesure 150a. Les indications de temps $t_{TH}$ ou de laps de temps $\Delta t_{TH}$ sont donc fournies toutes les minutes.

Le mode adaptatif est mis en oeuvre durant la phase de charge et comprend le calcul de nouveaux poids synaptiques Wkc pour le troisième réseau de neurones NN3, à partir de valeurs instantanées réelles Vt, t imposées au premier réseau de neurones NN1, à partir du calcul des paramètres réels WjA* et du calcul des paramètres d'erreur WjC* reportés sur le troisième réseau de neurones NN3, selon la procédure décrite plus haut en référence avec les FIG.1B et FIG.3.

D'une manière générale, en référence avec la FIG.5A dont la légende est au Tableau I, le système de contrôle 100 est mis en oeuvre par un microprocesseur 160 pour réaliser les calculs, et des zones mémoire 170a, 170b pour mémoriser les données. Ces zones mémoire sont accessibles par le microprocesseur 160 et incluent une zone mémoire de stockage ROM 170a pour stocker les données de structure des réseaux de neurones NN1, NN2 et NN3, les paramètres fixes et les poids WnB du second réseau de neurones, et une zone de mémoire vive RAM 170b pour enregistrer ou fournir selon le cas les mesures variables et les vecteurs de poids WjA, WjC, WjA*, WjC* du premier et du troisième réseaux de neurones. Le microprocesseur 160 effectue les calculs nécessaires au fonctionnement du système de contrôle.

En référence avec la FIG.5B, dont la légende est au Tableau II, le système de contrôle 100 est couplé à des moyens d'affichage 140 pour fournir à l'utilisateur une indication du temps $t_{TH}$ ou bien du laps de temps $\Delta t_{TH}$ restant à courir à partir d'un instant courant t d'utilisation jusqu'à l'instant où la batterie atteindra ce seuil de tension critique prédéterminé $Vt_{TH}$, ou bien les deux indications. Les moyens d'affichage 140 peuvent en outre afficher l'heure, c'est-à-dire une indication de l'instant courant ; ces moyens d'affichage peuvent en outre afficher une indication à l'issue de la phase de charge consécutive à la phase de décharge de la batterie, que cette phase de charge est terminée, lorsque la batterie a atteint la tension initiale Vo = 9V par exemple.

Comme cité précédemment, le système de contrôle 100 fait partie d'un dispositif hôte 130 qui comprend des moyens de connexion D1, D2 pour la batterie rechargeable 110. La batterie rechargeable 110 est couplée au système de contrôle 100 pour former la batterie intelligente 120. Le dispositif hôte 130 abrite en outre les moyens de mesure 150, par exemple un multimètre, le microprocesseur 160, les zones mémoire 170a, 170b accessibles par le microprocesseur 160 et les moyens d'affichage 140.

Pour la réalisation des moyens d'affichage, plusieurs dispositifs connus de l'état de la technique sont utilisables. Un dispositif peut être un écran avec des indications écrites, ou avec des indications dessinées, ou encore un panneau formée de diodes.

TABLEAU I

| (FIG.5A) | |
|---|---|
| 150a | Moyens de mesure du temps $t_o$, $t_o+\Delta_{to}$, t |
| 150b | Moyens de mesure des tensions $V_o$, $V_o+\Delta_{Vo}$, Vt |
| 110 | Batterie rechargeable |
| 160 | Microprocesseur pour effectuer les calculs $\Delta t_{TH}$ = t-$t_{TH}$, WjA = Wjb+Wjc, Wjc* = WjA*-WjB $\Delta$Vo = Vo-V'o, No |
| NN1 | Premier réseau de neurones |
| NN2 | Second réseau de neurones |
| NN3 | Troisième réseau de neurones |
| 170 | Zones de mémoire |

TABLEAU II

| | (FIG.5B) | |
|---|---|---|
| 130 | Dispositif hôte | |
| D1, D2 | Connexion du dispositif hôte et de la batterie | |
| 110 | Batterie rechargeable | |
| 150 | Moyens de mesure du temps, et des tensions | |
| 160 | Microprocesseur pour effectuer les calculs | |
| 170a | Zone de mémoire morte (ROM) | |
| 170b | Zone de mémoire vive (RAM) | |
| 100 | Système de contrôle de batterie | |
| 120 | Batterie intelligente | |
| 140 | Moyens d'affichage de l'instant courant et des temps calculés, et éventuellement de fin de charge. | |

TABLEAU III (FIG.3 et FIG.1B)

| 1 | Phase de décharge PD1 |
|---|---|
| | Fonctionnement en initialisation et usage courant |
| | 150a, 150b } Vo, Δto, No  Valeurs initiales |
| | fournissent   Vt,t       Valeurs instantanées |
| | NN2 fournit WjB poids approximatifs |
| 2 | Phase de charge PC1 suivante |
| | Apprentissage de NN3 pour adaptativité |

| | 2a | NN1 reçoit Vt en entrée |
|---|---|---|
| | | t en sortie |
| | | fournit WjA* poids réels |
| | 2b | 160 reçoit WjA*, WjB |
| | | fournit les paramètres d'erreurs |
| | | WjC* = WjA*-WjB |
| | 2c | NN3 reçoit Vo, ΔVo, No en entrée |
| | | WjC* en sortie |
| | | fournit ses propres poids |
| | | adaptatifs WkC |

| 3 | Phase de décharge suivante |
|---|---|
| | Fonctionnement en initialisation puis usage courant |

**Revendications**

1. Système de contrôle (100) des cycles de décharge-charge d'une batterie destiné à être couplé à une batterie rechargeable (110) ayant des phases de charge alternant avec des phases de décharge selon des cycles de décharge-charge, ce système comprenant :

   des premiers moyens de calcul adaptatifs (NN1) qui sont arrangés pour collecter, au commencement d'une phase de décharge d'un cycle de décharge-charge de la batterie, un lot de paramètres de fonctionnement appelés premiers paramètres (WjA), et pour recevoir en entrée une valeur prédéterminée d'un seuil critique $(V_{TH},)$ de tension de décharge, et qui sont arrangés pour fournir en sortie une indication prédictive calculée de l'instant $(t_{TH})$ où la batterie atteindra ce seuil critique $(V_{TH})$ correspondant à la fin de cette phase de décharge,

   ce système comprenant aussi :

   des seconds et des troisièmes moyens de calcul adaptatifs (NN2,NN3), couplés aux premiers moyens de calcul, qui sont arrangés pour recevoir, en entrée, à un instant initial, au commencement de ladite phase de décharge de la batterie, une valeur de la tension de batterie appelée tension initiale (Vo), une valeur d'une variation (ΔVo) de cette tension initiale après un court laps de temps à partir de cet instant initial, et une valeur du nombre initial (No) de cycles de décharge-charge de cette batterie, effectués antérieurement à ladite phase de décharge, et qui sont arrangés pour fournir en sortie, dès l'instant de ladite phase de décharge où les valeurs initiales sont disponibles, respectivement, un lot de paramètres approximatifs et un lot de paramètres correspondants de correction (WjC) qui sont additionnés pour fournir lesdits premiers paramètres de fonctionnement (WjA) imposés aux dits premiers moyens de calcul (NN1);
   et un calculateur (160) applicable aux dits paramètres.

2. Système de contrôle selon la revendication 1, comprenant aussi une zone de mémoire vive (170b) pour enregistrer durant ladite phase de décharge, des lots de valeurs réelles instantanées formés chacun d'une mesure de la tension de décharge (Vt) de la batterie et l'instant courant (t) correspondant à cette mesure,
   le système de contrôle étant arrangé en sorte que, durant la phase de charge (PC1) de la batterie qui suit ladite phase de décharge (PD1) du cycle de décharge-charge concerné :

   les premiers moyens de calcul (NN1) sont en outre arrangés pour calculer A POSTERIORI de manière autonome et fournir des paramètres appelés paramètres réels (WjA*) qui correspondent au fonctionnement de ces premiers moyens de calcul (NN1) dans la situation où les lots de valeurs réelles instantanées leurs sont imposés, avec la mesure de tension (Vt) de décharge imposée en entrée et l'instant courant (t) correspondant imposé en sortie,
   le calculateur (160) est arrangé pour recevoir lesdits paramètres approximatifs (WjB) calculés par les seconds moyens de calcul (NN2) durant la phase de décharge (PD1), et lesdits paramètres réels (WjA*) calculés par les premiers moyens de calcul (NN1) durant la phase de charge (PC1), et pour fournir des différences respectives entre ces paramètres, appelées paramètres d'erreurs (WjC*), et
   les troisièmes moyens de calcul (NN3) sont arrangés pour calculer de manière autonome des paramètres appelés paramètres adaptatifs (WkC) qui correspondent au fonctionnement de ces troisièmes moyens de calcul dans la situation où les paramètres d'erreurs (WjC*) leur sont imposés en sortie, alors que les valeurs initiales (Vo, AVo, No) de la phase de décharge (PD1) antérieure leur sont imposées en entrée,
   et le système de contrôle étant arrangé en sorte que les troisièmes moyens de calcul (NN3) conservent comme paramètres de fonctionnement, dans la phase de décharge ultérieure du cycle de décharge-charge suivant, les paramètres adaptatifs (WkC), calculés dans ladite phase de charge (PC1).

3. Système de contrôle selon l'une des revendications 1 ou 2, dans lequel :

   les premier, second et troisième moyens de calcul (NN1, NN2, NN3) sont constitués respectivement par un premier, second et troisième réseaux de neurones, les premiers paramètres de fonctionnement sont les coefficients synaptiques (WjA) du premier réseau de neurones, le premier réseau de neurone (NN1) ayant une cellule d'entrée (NE1A) pour une valeur de tension, et une cellule de sortie (NSA) pour une valeur de temps, le second réseau de neurone ayant trois cellules d'entrée (NE1B, NE2B, NE3B) pour lesdites valeurs initiales (Vo, ΔVo, No) et un nombre de cellules de sortie (NS1B-NS13B) pour les paramètres approximatifs (WjB) en nombre égal au nombre des coefficients synaptiques (WjA) du premier réseau de neurones (NNI),

et le troisième réseau de neurones (NN3) ayant trois cellules d'entrée (NE1C, NE2C, NE3C) pour lesdites valeurs initiales (Vo, $\Delta$Vo, No) et un nombre de cellules de sortie (NS1C-NS13C) pour les paramètres de correction (WjC) en nombre égal au nombre des coefficients synaptiques (WjA) du premier réseau de neurones (NN1), et dans lequel :

le calculateur (160) est arrangé, dans la phase de décharge, pour recevoir et additionner les paramètres approximatifs (WjB) et les paramètres de correction (WjC) et pour fournir lesdits coefficients synaptiques (WjA) imposés au premier réseau de neurones (NN1).

4. Système de contrôle selon la revendication 3, dans lequel :

le premier réseau de neurones (NN1) réalisant les premiers moyens de calcul, est arrangé pour calculer, durant la phase de charge (PC1) qui suit la phase de décharge (PD1) du cycle de décharge-charge concerné par une méthode de rétropropagation, des paramètres réels (WjA*) qui sont ses propres coefficients synaptiques réels dans la situation où, pour chaque lot de valeurs réelles instantanées, la mesure de tension (Vt) de décharge est imposée à son entrée, et l'instant courant (t) correspondant est imposé à sa sortie, le calculateur (160) est arrangé pour fournir les paramètres d'erreurs (WjC*) formés par les différences respectives entre lesdits coefficients synaptiques réels (WjA*) calculés par le premier réseau de neurones (NN1) durant ladite phase de charge (PC1), et lesdits paramètres approximatifs (WjB) calculés par le second réseau de neurones (NN2) pour ladite phase de décharge (PD1) antérieure, le troisième réseau de neurones (NN3) réalisant les troisièmes moyens de calcul, est arrangé pour calculer, par une méthode de rétropropagation, les paramètres adaptatifs (WkC) qui sont ses propres coefficients synaptiques adaptatifs, dans la situation où les paramètres d'erreurs (WkC*) sont imposés à ses sorties et les valeurs initiales (Vo, $\Delta$Vo, No) de la phase de décharge (PD1) antérieure sont imposées à ses entrées, ce troisième réseau de neurones (NN3) conservant, dans la phase de décharge (PD2) ultérieure du cycle de décharge-charge suivant, ces coefficients synaptiques adaptatifs (WkC), calculés dans ladite phase de charge.

5. Système de contrôle selon l'une des revendications 1 ou 2, dans lequel:
le calculateur (160) est aussi arrangé pour calculer et fournir, à chaque instant courant (t), à partir de la mesure de cet instant courant (t) et à partir de l'indication prédictive de l'instant critique ($t_{TH}$) fournie par les premiers moyens de calcul adaptatifs, une indication prédictive du laps de temps ($\Delta t_{TH}$) restant à courir à partir de cet instant courant (t) jusqu'à l'instant critique ($t_{TH}$) où la batterie atteindra le seuil critique prédétermine de tension de décharge ($V_{TH}$).

6. Système de contrôle selon l'une des revendications 3 ou 4, dans lequel:

le calculateur est aussi arrangé pour calculer et fournir à chaque instant courant (t), à partir de la mesure de cet instant courant (t) et à partir de l'indiction prédictive de l'instant critique ($t_{TH}$) fournie par le premier réseaux de neurones, une indication prédictive du laps de temps ($\Delta t_{TH}$) restant à courir à partir de cet instant courant (t) jusqu'à l'instant critique ($t_{TH}$) où la batterie atteindra ce seuil critique prédéterminé de tension de décharge (VTH).

7. Système de contrôle selon l'une des revendications 3, 4 ou 6, dans lequel le second réseau de neurones (NN2) est monté en série avec le premier réseau de neurones (NN1), et dans lequel le troisième réseau de neurones (NN3) est monté en parallèle sur le second réseau de neurones.

8. Système de contrôle selon la revendication 7, dans lequel le premier réseau de neurones (NN1) a trois couches, dont une couche d'entrée d'une cellule neuronale (NE1A) pour une valeur de tension, a une couche cachée de cellules neuronales et une couche de sortie ayant une seule cellule neuronale (NSA), les cellules de la couche cachée ayant une fonction d'activation sigmoïde de pente différente d'une cellule à l'autre, et la cellule de la couche de sortie ayant une fonction d'activation linéaire.

9. Système de contrôle selon la revendication 8, dans lequel le second réseau de neurone (NN2) a trois couches de cellules neuronales, dont une couche d'entrée de trois cellules neuronales (NE1B, NE2B, NE3B) pour chacune des valeurs initiales (Vo, $\Delta$Vo, No), une couche de cellules cachées, et une couche de sortie de cellules neuronales (NS1B-NS13B), les cellules de la couche cachée (NC1B-NC8B) ayant une fonction d'activation sigmoide de pente différente d'une cellule à l'autre, et les cellules de la couche de sortie étant en nombre égal au nombre des coefficients synaptiques nécessaires au fonctionnement du premier réseau de neurones et ayant une fonction d'activation sigmoïde.

**10.** Système de contrôle selon la revendication 9, dans lequel le troisième réseau de neurones (NN3) a trois couches de cellules neuronales, dont une couche d'entrée à trois cellules neuronales (NE1C, NE2C, NE3C) pour chacune des valeurs initiales (Vo, ΔVo, No), une couche d'une seule cellule cachée (AU), et une couche de sortie de cellules neuronales (NS1C-NS13C), les cellules de la couche de sortie étant en nombre égal au nombre des coefficients synaptiques nécessaires au fonctionnement du premier réseau de neurones (NN1), et ayant une fonction d'activation sigmoide.

**11.** Système de contrôle selon l'une des revendications 4 à 10 comprenant un microprocesseur (160) pour effectuer les calculs, pour réaliser les premier, second et troisième réseaux de neurones ainsi que le calculateur, et des zones de mémoire (170a, 170b) pour mémoriser les données, ces zones de mémoire étant accessibles par le microprocesseur (160) et incluant une zone de mémoire de stockage (170a) pour stocker les données de structure des réseaux de neurones, les paramètres fixes et les coefficients synaptiques du second réseau de neurones, et une zone de mémoire vive (170b) pour enregistrer ou fournir les mesures variables, et les coefficients synaptiques des premier et troisième réseaux de neurones.

**12.** Système de contrôle selon l'une des revendications 1 à 11, ce système (100) étant couplé à une batterie rechargeable (110), à des moyens de mesure de temps (150a), de mesure de tension (150b), et à des moyens d'affichage (140) arrangés pour fournir soit une indication de l'instant critique ($t_{TH}$) où la batterie atteindra le seuil de tension critique ($Vt_{TH}$), soit une indication du laps de temps ($\Delta t_{TH}$) restant à courir à partir d'un instant courant (t) d'utilisation jusqu'à l'instant ($t_{TH}$) où la batterie atteindra un seuil de tension critique prédéterminé ($Vt_{TH}$), soit les deux indications, et éventuellement une indication de la fin de phase de recharge de batterie.

**13.** Dispositif hôte (130) comprenant un système de contrôle (100) selon la revendication 12, ce dispositif hôte étant alimenté par la batterie rechargeable (110) qui est couplée au dit système de contrôle.

**14.** Procédé d'entraînement des réseaux de neurones du système de contrôle selon l'une des revendications 7 à 12, comprenant dans une phase d'apprentissage:

l'apprentissage, par le premier réseau de neurones, de courbes de temps de décharge (t) en fonction de la tension de décharge (Vt), durant lequel des tensions de décharge (Vt) sont imposées à l'entrée du premier réseau de neurones normalement destinée à la valeur de tension, et les temps (t) correspondants à la sortie, pour former une base de données constituée de vecteurs des coefficients synaptiques (WjA) de ce premier réseau de neurones,
l'apprentissage par le second réseau de neurones de relations entre les valeurs initiales (Vo, ΔVo, No) et les coefficients (WjA) synaptiques du premier réseau de neurones, détermines dans sa procédure d'apprentissage,
l'apprentissage du troisième réseau de neurones pour lui faire déterminer ses propres coefficients synaptiques adaptatifs (WkC), cet apprentissage comprenant les étapes de :

1) dans la phase de décharge (PD1) d'un cycle de décharge-charge de la batterie, mémorisation des valeurs initiales (Vo, ΔVo, No), et des valeurs réelles instantanées de tension de batterie (Vt) en fonction de l'instant courant correspondant (t), et des paramètres approximatifs (WjB) fournis par le second réseau de neurones (NN2),
2) dans la phase de charge ultérieure (PC1), cet apprentissage comprenant les sous-étapes de :

2a) calcul par le premier réseau de neurones de ses propres coefficients synaptiques réels (WjA*) lorsque les valeurs instantanées de tension (Vt) et temps (t) sont respectivement imposées à son entrée et à sa sortie,
2b) calcul de paramètres d'erreurs (WjC*) en effectuant les différences respectives entre les paramètres réels (WjA*) et les paramètres approximatifs (WjB),
2c) calcul par le troisième réseau de neurones (NN3) de ses propres coefficients synaptiques (WkC) appelés paramètres adaptatifs, lorsque les paramètres d'erreurs (WjC*) sont imposés à sa sortie et les valeurs initiales (Vo, ΔVo, No) sont imposées à ses entrées,

et procédé d'utilisateur du système de contrôle comprenant l'utilisation desdits paramètres adaptatifs (WkC) comme coefficients synaptiques du troisième réseau de neurones (NN3) dans la phase ultérieure de décharge du cycle de décharge-charge suivant.

**Patentansprüche**

1. Steuerungssystem (100) der Entlade/Lade-Zyklen einer Batterie, um mit einer wiederaufladbaren Batterie (110) mit Ladephasen, die mit Entladephasen entsprechend Entlade/Lade-Zyklen abwechseln, verknüpft zu werden, wobei dieses System enthält:

   Erste adaptive Rechenmittel (NN1), die ausgelegt sind, um bei Beginn einer Entladephase eines Entlade/Lade-Zyklus der Batterie einen Funktionsparametersatz mit der Bezeichnung erste Parameter (WjA) zu sammeln und um am Eingang einen vorbestimmten Grenzwert ($V_{TH}$) einer kritischen Entladespannung zu erhalten, und die ausgelegt sind, um am Ausgang eine berechnete voraussagende Angabe über den Zeitpunkt ($t_{TH}$) auszugeben, in dem die Batterie diesen kritischen Grenzwert ($V_{TH}$) erreicht, welcher dem Ende dieser Entladephase entspricht,

   wobei dieses System außerdem enthält:

   Zweite und dritte, mit den ersten Rechenmitteln verknüpfte adaptive Rechenmittel (NN2, NN3), die ausgelegt sind, um am Eingang in einem Initialzeitpunkt bei Beginn der besagten Entladephase der Batterie einen Wert der Batteriespannung mit der Bezeichnung Initialspannung (Vo), einen Wert einer Variation ($\Delta$Vo) dieser Initialspannung nach einem kurzen Zeitraum ausgehend von diesem Initialzeitpunkt und einen Wert der Initialzahl (No) der Entlade/Lade-Zyklen dieser Batterie zu erhalten, die vor der besagten Entladephase ausgeführt wurden, und die ausgelegt sind, um am Ausgang ab dem Zeitpunkt der besagten Entladephase, in dem die Initialwerte zur Verfügung stehen, respektive einen Satz Näherungsparameter und einen Satz entsprechender Korrekturparameter (WjC) auszugeben, die addiert werden, um die besagten ersten Funktionsparameter (WjA) zu ergeben, welche den besagten ersten Rechenmitteln (NN1) vorgegeben werden; und einen auf die besagten Parameter anwendbaren Rechner (160).

2. Steuerungssystem (160) nach Anspruch 1, das auch eine Arbeitsspeicherzone (170b) zum Aufzeichnen während der besagten Entladephase der Sätze mit momentan reellen Werten enthält, jeweils aus einer Messung der Entladespannung (Vt) der Batterie und dem dieser Messung entsprechenden laufenden Zeitpunkt (t) gebildet, wobei das Steuerungssystem derart ausgelegt ist, dass während der Ladephase (PC1) der Batterie, welche der besagten Entladephase (PD 1) des betreffenden Entlade/Lade-Zyklus folgt:

   Die ersten Rechenmittel (NN1) außerdem ausgelegt sind, um A POSTERIORI auf autonome Weise zu rechnen und Parameter mit der Bezeichnung reelle Parameter (WjA*) auszugeben, welche der Funktionsweise dieser ersten Rechenmittel (NN1) in der Situation entsprechen, in der ihnen die Sätze mit momentan reellen Werten vorgegeben werden, mit der Messung der am Eingang vorgegebenen Entladespannung (Vt) und des am Ausgang vorgegebenen entsprechenden laufenden Zeitpunkts (t), der Rechner (160) für den Erhalt der besagten von den zweiten Rechenmitteln (NN2) während der Entladephase (PD1) berechneten Näherungsparameter (WjB) und der besagten von den ersten Rechenmitteln (NN1) während der Ladephase (PC1) berechneten reellen Parameter (WjA*) und für die Ausgabe der respektiven Differenzen zwischen diesen Parametern mit der Bezeichnung Fehlerparameter (WjC*) ausgelegt ist, und die dritten Rechenmittel (NN3) außerdem zur Berechnung der Parameter mit der Bezeichnung Adaptationsparameter (WkC) auf autonome Weise ausgelegt sind, welche der Funktionsweise dieser dritten Rechenmittel in der Situation entsprechen, in der ihnen die Fehlerparameter (WjC*) am Ausgang vorgegeben werden, während ihnen die Initialwerte (Vo, AVo, No) der vorhergehenden Entladephase (PD1) am Eingang vorgegeben werden, und das Steuerungssystem derart ausgelegt ist, dass die dritten Rechenmittel (NN3) in der nachfolgenden Entladephase des folgenden Entlade/Lade-Zyklus die in der besagten Ladephase (PC1) berechneten Adaptationsparameter (WkC) als Funktionsparameter beibehalten.

3. Steuerungssystem nach einem der Ansprüche 1 oder 2, in dem:

   Die ersten, zweiten und dritten Rechenmittel (NN1, NN2, NN3) respektive aus einem ersten, zweiten und dritten Neuronennetz gebildet werden, die ersten Funktionsparameter die synaptischen Koeffizienten (WjA) des ersten Neuronennetzes sind, wobei das erste Neuronennetz eine Eingangszelle (NE1A) für einen Spannungswert und eine Ausgangszelle für einen Zeitwert hat,

das zweite Neuronennetz drei Eingangszellen (NE1B, NE2B, NE3B) für die besagten Initialwerte (Vo, ΔVo, No) und eine Anzahl von Ausgangszellen (NS1B-NS13B) für die Näherungsparameter (WjB) in gleicher Anzahl wie die Anzahl der synaptischen Koeffizienten (WjA) des ersten Neuronennetzes (NN1) hat, und

das dritte Neuronennetz (NN3) drei Eingangszellen (NE1C, NE2C, NE3C) für die besagten Initialwerte (Vo, ΔVo, No) und eine Anzahl von Ausgangszellen (NS1C-NS 13C) für die Korrekturparameter (WjC) in gleicher Anzahl wie die Anzahl der synaptischen Koeffizienten (WjA) des ersten Neuronennetzes (NN1) hat, und in dem:

Der Rechner (160) in der Entladephase für die Entgegennahme und Addition der Näherungsparameter (WjB) und der Korrekturparameter (WjC) und für die Ausgabe der besagten dem ersten Neuronennetz (NN1) vorgegebenen synaptischen Koeffizienten (WjA) ausgelegt ist.

4. Steuerungssystem nach Anspruch 3, in dem:

Das erste Neuronennetz (NN1) für die Umsetzung der ersten Rechenmittel während der Ladephase (PC 1) ausgelegt ist, welche der Entladephase (PD1) des von einer Rückübertragungsmethode betroffenen Entlade/Lade-Zyklus folgt, zur Berechnung der reellen Parameter (WjA*), welche seine eigenen reellen synaptischen Koeffizienten in der Situation sind, in der für jeden Satz mit momentan reellen Werten die Messung der Entladespannung (Vt) an seinem Eingang und des entsprechenden Stromzeitpunkts (t) an seinem Ausgang vorgegeben wird,

der Rechner (160) ausgelegt ist, um die Fehlerparameter (WjC*) auszugeben, die von den respektiven Differenzen zwischen den besagten vom ersten Neuronennetz (NN1) während der besagten Ladephase (PC1) berechneten reellen synaptischen Koeffizienten (WjA*) und den besagten vom zweiten Neuronennetz (NN2) für die besagte vorhergehende Entladephase (PD1) berechneten Näherungsparametern (WjB) gebildet wird,

wobei das dritte Neuronennetz (NN3) zur Umsetzung der dritten Rechenmittel ausgerichtet ist, um mit einer Rückübertragungsmethode die Adaptationsparameter (WkC) zu berechnen, welche in der Situation seine eigenen synaptischen Adaptationskoeffizienten sind, in der die Fehlerparameter (WkC*) an seinen Ausgängen vorgegeben werden und die Initialwerte (Vo, ΔVo, No) der vorhergehenden Entladephase (PD1) an seinen Eingängen vorgegeben werden, und

dieses dritte Neuronennetz (NN3) in der nachfolgenden Entladephase (PD2) des folgenden Entlade/Lade-Zyklus diese in der besagten Ladephase berechneten synaptischen Koeffizienten (WkC) beibehält.

5. Steuerungssystem nach einem der Ansprüche 1 oder 2, in dem:

Der Rechner (160) auch für die Berechnung und Ausgabe ausgelegt ist, um in jedem laufenden Zeitpunkt (t) anhand der Messung dieses laufenden Zeitpunkts (t) und anhand der voraussagenden Anzeige des von den ersten adaptiven Rechenmitteln bereitgestellten kritischen Zeitpunkts ($t_{TH}$), einer voraussagenden Anzeige des Zeitraums ($\Delta t_{TH}$), der ausgehend von diesem laufenden Zeitpunkt (t) bis zu dem kritischen Zeitpunkt ($t_{TH}$) verbleibt, in dem die Batterie den vorbestimmten kritischen Grenzwert der Entladespannung ($V_{TH}$) erreicht.

6. Steuerungssystem nach einem der Ansprüche 3 oder 4, in dem:

Der Rechner auch für die Berechnung und Ausgabe ausgelegt ist, um in jedem laufenden Zeitpunkt (t) anhand der Messung dieses laufenden Zeitpunkts (t) und anhand der voraussagenden Anzeige des von dem ersten Neuronennetz bereitgestellten kritischen Zeitpunkts ($t_{TH}$), einer voraussagenden Anzeige des Zeitraums ($\Delta t_{TH}$), der ausgehend von diesem laufenden Zeitpunkt (t) bis zu dem kritischen Zeitpunkt ($t_{TH}$) verbleibt, in dem die Batterie den vorbestimmten kritischen Grenzwert der Entladespannung ($V_{TH}$) erreicht.

7. Steuerungssystem nach einem der Ansprüche 3, 4 oder 6, in dem das zweite Neuronennetz (NN2) in Serie mit dem ersten Neuronennetz (NN1) geschaltet ist, und in dem das dritte Neuronennetz (NN3) parallel zum zweiten Neuronennetz geschaltet ist.

8. Steuerungssystem nach Anspruch 7, in dem das erste Neuronennetz (NN1) drei Schichten hat, worunter eine Eingangsschicht einer neuronalen Zelle (NE1A) für einen Spannungswert, eine versteckte Schicht von neuronalen Zellen und eine Ausgangsschicht mit einer einzigen neuronalen Zelle (NSA), wobei die Zellen der versteckten Schicht eine Sigma-Aktivierungsfunktion mit unterschiedlicher Neigung von einer zur anderen Zelle haben und die Zelle der Ausgangsschicht eine lineare Aktivierungsfunktion hat.

9. Steuerungssystem nach Anspruch 8, in dem das zweite Neuronennetz (NN2) drei Schichten mit neuronalen Zellen hat, worunter eine Eingangsschicht mit drei neuronalen Zellen (NE1B, NE2B, NE3B) für jeden der Initialwerte (Vo, $\Delta$Vo, No), eine Schicht mit versteckten Zellen und eine Ausgangsschicht mit neuronalen Zellen (NS1B-NS 13B), wobei die Zellen der versteckten Schicht in der Anzahl den synaptischen Koeffizienten entsprechen, die für die Funktionsweise des ersten Neuronennetzes erforderlich sind und eine Sigma-Aktivierungsfunktion haben.

10. Steuerungssystem nach Anspruch 9, in dem das dritte Neuronennetz (NN3) drei Schichten mit neuronalen Zellen hat, worunter eine Eingangsschicht mit drei neuronalen Zellen (NE1C, NE2C, NE3C) für jeden der Initialwerte (Vo, $\Delta$Vo, No), eine Schicht mit einer einzigen versteckten Zelle (AU) und eine Ausgangsschicht mit neuronalen Zellen (NS1C-NS13C), wobei die Zellen der Ausgangsschicht in der Anzahl den synaptischen Koeffizienten entsprechen, die für die Funktionsweise des ersten Neuronennetzes (NN1) erforderlich sind, und eine Sigma-Aktivierungsfunktion haben.

11. Steuerungssystem nach einem der Ansprüche 4 bis 10 mit einem Mikroprozessor (160) zum Ausführen von Berechnungen, um das erste, zweite und dritte Neuronennetz sowie den Rechner und die Speicherzonen (170a, 170b) zum Abspeichern von Daten zu verkörpern, wobei diese Speicherzonen für den Mikroprozessor (160) zugänglich sind und eine Speicherzone (170a) zum Abspeichern der Strukturdaten der Neuronennetze, der festen Parameter und der synaptischen Koeffizienten des zweiten Neuronennetzes und eine Arbeitsspeicherzone (170b) zum Aufzeichnen oder Ausgeben der variablen Messungen und der synaptischen Koeffizienten des ersten und dritten Neuronennetzes beinhalten.

12. Steuerungssystem nach einem der Ansprüche 1 bis 11, wobei dieses System (100) an eine wiederaufladbare Batterie (110), an Mittel zum Messen der Zeit (150a), zum Messen der Spannung (150b) und an Anzeigemittel (140) gekoppelt ist, die angeordnet sind, um entweder eine Anzeige des kritischen Zeitpunkts ($t_{TH}$) auszugeben, in dem die Batterie den kritischen Spannungsgrenzwert ($Vt_{TH}$) erreicht, oder eine Anzeige des Zeitraums ($\Delta t_{TH}$) der ausgehend von einem laufenden Zeitpunkt (t) der Anwendung bis zu dem Zeitpunkt ($t_{TH}$) verbleibt, in dem die Batterie einen vorbestimmten kritischen Spannungsgrenzwert ($Vt_{TH}$) erreicht, oder auch beide Anzeigen und eventuell eine Anzeige des Endes der Wiederaufladephase der Batterie.

13. Zugehörige Vorrichtung (130) mit einem Steuerungssystem (100) nach Anspruch 12, wobei diese zugehörige Vorrichtung von der wiederaufladbaren Batterie versorgt wird, mit der das besagte Steuerungssystem verknüpft ist.

14. Lernverfahren für Neuronennetze des Steuerungssystems nach einem der Ansprüche 7 bis 12 mit in einer Lernphase:

Das Erlernen vom ersten Neuronennetz von Kurven der Entladezeit (t) unter Berücksichtigung der Entladespannung (Vt), während Entladespannungen (Vt) am Eingang des ersten Neuronennetzes vorgegeben werden, normalerweise für den Spannungswert bestimmt, und der entsprechenden Zeiten (t) am Ausgang, um eine Datenbank zu bilden, die aus Vektoren der synaptischen Koeffizienten (WjA) dieses ersten Neuronennetzes gebildet werden,
das Erlernen vom zweiten Neuronennetz von Relationen zwischen den Initialwerten (Vo, $\Delta$Vo, No) und den synaptischen Koeffizienten (WjA) des ersten Neuronennetzes, in seinem Lernverfahren bestimmt,
das Lernen des dritten Neuronennetzes, um ihn seine eigenen adaptiven synaptischen Koeffizienten (WkC) bestimmen zu lassen, wobei dieses Lernen die Schritte umfasst:

1) In der Entladephase (PD1) eines Entlade/Lade-Zyklus der Batterie die Speicherung der Initialwerte (Vo, $\Delta$Vo, No) und der momentan reellen Werte der Batteriespannung unter Berücksichtigung des entsprechenden laufenden Zeitpunkts (t) und der vom zweiten Neuronennetz (NN2) bereitgestellten Näherungsparameter (WjB),
2) in der späteren Ladephase (PC1) beinhaltet dieses Lernen die Unterschritte der:

2a) Berechnung vom ersten Neuronennetz seiner eigenen reellen synaptische Koeffizienten (WjA*), wenn die momentanen Spannungs- (Vt) und Zeitwerte (t) respektive an seinem Eingang und seinem Ausgang vorgegeben werden,
2b) Berechnung der Fehlerparameter (WjC*), indem die respektiven Differenzen zwischen den reellen Parametern (WjA*) und den Näherungsparametern (WjB) genommen werden,
2c) Berechnung vom dritten Neuronennetz (NN3) seiner eigenen synaptischen Koeffizienten (WkC) mit der Bezeichnung adaptive Parameter, wenn die Fehlerparameter (WjC*) an seinem Ausgang vor-

EP 0 772 056 B1

gegeben werden und die Initialwerte (Vo, ΔVo, No) an seinen Eingängen vorgegeben werden, und

Anwenderverfahren des Steuerungssystems mit der Verwendung der besagten Adaptationsparameter (WkC) als synaptische Koeffizienten des dritten Neuronennetzes (NN3) in der nachfolgenden Entladephase des folgenden Entlade/Lade-Zyklus.

**Claims**

**1.** A monitoring system (100) for monitoring discharge/charge cycles of a battery intended to be coupled to a rechargeable battery (110) having charge periods which alternate with discharge periods depending on discharge/charge cycles, this system comprising:

first adaptive calculation means (NN1) which are arranged for collecting at the beginning of a discharge period of a discharge/charge cycle of the battery a batch of operating parameters called first parameters (WjA), and for receiving on the input a predetermined value of a critical discharge voltage threshold ($V_{TH}$), and which are arranged for producing on the output a calculated predictive indication of the instant ($t_{TH}$) at which the battery will reach this critical threshold ($V_{TH}$) that corresponds to the end of this discharge period,

this system also comprising:

second and third adaptive calculation means (NN2, NN3) coupled to the first calculation means, which are arranged for receiving on the input, at an initial instant, at the beginning of said discharge period of the battery, a value of the battery voltage called initial voltage (Vo), a value of a variation (ΔVo) of this initial voltage after a short lapse of time starting from this initial instant, and a value of the initial number (No) of discharge/charge cycles of this battery effected before said discharge period, and which are arranged for producing on the output from the instant of said discharge period at which the initial values are available, a batch of approximate parameters and a batch of corresponding correction parameters (WjC) respectively, which are added together to form said first operating parameters (WjA) imposed on said first calculation means (NN1) and a calculator that can be applied to said parameters.

**2.** A monitoring system as claimed in claim 1, also comprising a read/write memory area (170b) for recording during said discharge period batches of instantaneous real values formed each by a discharge voltage measurement (Vt) of the battery and by the current instant (t) corresponding to this measurement,
the monitoring system being arranged so that during the battery charge period (PC1) following said discharge period (PD1) of the respective discharge/charge cycle:

the first calculation means (NN1) are furthermore arranged for calculating a posteriori in an autonomous manner, and for producing parameters called real parameters (WjA*) which correspond to the operation of these first calculation means (NN1) in the situation when the batches of instantaneous real values are imposed on them, while the discharge voltage measurement (Vt) is imposed on the input and the corresponding current instant (t) is imposed on the output,
the calculator (160) is arranged for receiving said approximate parameters (WjB) calculated by the second calculation means (NN2) during the discharge period (PD1), and said real parameters (WjA*) calculated by the first calculation means (NN1) during the charge period (PC1), and for producing respective differences between these parameters called error parameters (WjC*), and
the third calculation means (NN3) are arranged for calculating autonomously parameters called adaptive parameters (WkC) which correspond to the operation of these third calculation means in the situation when the error parameters (WjC*) are imposed on them, at the output, whereas the initial values (Vo, ΔVo, No) of the previous discharge period (PD1) are imposed on them, at the input,
and in which system the third calculation means (NN3) are arranged so that the third calculation means (NN3) maintains as operating parameters in the later discharge period of the next discharge/charge cycle the adaptive parameters (WkC) calculated in said charge period (PC1).

**3.** A monitoring system as claimed in one of the claims 1 or 2, in which:

the first, second and third calculation means (NN1, NN2, NN3) are formed by a first, second and third neural network respectively, the first operating parameters are the synaptic coefficients (WjA) of the first neural network, the first neural network (NN1) having an input cell (EC1A) for a voltage value and an output cell (NSA) for a time value,

the second neural network having three input cells (NE1B, NE2B, NE3B) for said initial values (Vo, ΔVo, No) and a number of output cells (NS1B - NS13B) for the approximate parameters (WjB) which is equal to the number of synaptic coefficients (WjA) of the first neural network (NN1), and

the third neural network (NN3) having three input cells (NE1C, NE2C, NE3C) for said initial values (Vo, ΔVo, No) and a number of output cells (NS1C - NS13C) for the correction parameters (WjC) which is equal to the number of synaptic coefficients (WjA) of the first neural network (NN1), and in which monitoring system:

the calculator (160) is arranged for receiving and adding together in the discharge period the approximate parameters (WjB) and the correction parameters (WjC) and for producing said synaptic coefficients (WjA) imposed on the first neural network (NN1).

4. A monitoring system as claimed in claim 3, in which:

the first neural network (NN1), which forms the first calculation means, is arranged for calculating during the charge period (PC1) that follows the discharge period (PD1) of the respective discharge/charge cycle, by a reverse propagation method, real parameters (WjA*) which are its own real synaptic coefficients, in the situation when for each batch of instantaneous real values the measurement of the discharge voltage (Vt) is imposed at its input, and the corresponding current instant (t) is imposed at its output,

the calculator (160) is arranged for producing the error parameters (WjC*) formed by the respective differences between said real synaptic coefficients (WjA*) calculated by the first neural network (NN1) during said charge period (PC1), and said approximate parameters (WjB) calculated by the second neural network (NN2) for said previous discharge period (PD1),

the third neural network (NN3) forming the third calculation means is arranged for calculating, via a reverse propagation method, the adaptive parameters (WkC) which are its own adaptive synaptic coefficients, in the situation when the error parameters (WkC*) are imposed on its outputs and the initial values (Vo, ΔVo, No) of the previous discharge period (PD1) are imposed on its inputs, and

this third neural network (NN3) in the subsequent discharge period (PD2) of the next discharge/charge cycle maintains these adaptive synaptic coefficients (WkC) calculated in said charge period.

5. A monitoring system as claimed in one of the claims 1 or 2, in which:

the calculator (160) is also arranged for calculating and producing at each current instant (t) on the basis of the measurement of this current instant (t) and on the basis of the predictive indication of the critical instant ($t_{TH}$) produced by the first adaptive calculation means, a predictive indication of the lapse of time ($\Delta t_{TH}$) that is left from this current instant (t) onwards until the critical instant ($t_{TH}$) at which the battery will reach the predetermined critical discharge voltage threshold ($V_{TH}$).

6. A monitoring system as claimed in one of the claims 3 or 4, in which:

the calculator is also arranged for calculating and producing at each current instant (t) on the basis of the measurement of this current instant (t) and on the basis of the predictive indication of the critical instant ($t_{TH}$) produced by the first neural network a predictive indication of the lapse of time ($\Delta t_{TH}$) that is left from this current instant (t) onwards until the critical instant ($t_{TH}$) at which the battery will reach its predetermined critical discharge voltage threshold ($V_{TH}$)·

7. A monitoring system as claimed in any one of the claims 3, 4 or 6, in which the second neural network (NN2) is combined in series with the first neural network (NN1), and in which the third neural network (NN3) is combined in parallel with the second neural network.

8. A monitoring system as claimed in claim 7, in which the first neural network (NN1) has three layers, of which one input layer of a neural cell (NE1A) for a voltage value has a hidden layer of neural cells and an output layer having a single neural cell (NSA), the cells of the hidden layer having a sigmoidal activating function with slopes varying from one cell to the next, and the cell of the output layer having a linear activating function.

9. A monitoring system as claimed in claim 8, in which the second neural network (NN2) has three neural cell layers, of which one input layer of three neural cells (NE1B, NE2B, NE3B) for each of the initial values (Vo, ΔVo, No), one layer of hidden cells, and one output layer of neural cells (NS1B-NS13B), the cells of the hidden layer (NC1B-NC8B) having a sigmoidal activating function with different slopes from one cell to the next, and the number of cells of the output layer being equal to the number of synaptic coefficients which are necessary for the operation of the first neural network and having a sigmoidal activating function.

10. A monitoring system as claimed in claim 9 in which the third neural network (NN3) has three neural cell layers, of which one input layer of three neural cells (ME1C, NE2C, NE3C) for each of the initial values (Vo, $\Delta$Vo, No), one layer of a single hidden cell (AU), and one output layer of neural cells (NS1C-NS13C), the number of cells of the output layer being equal to the number of synaptic coefficients necessary for the operation of the first neural network (NN1), and having a sigmoidal activating function.

11. A monitoring system as claimed in any one of the claims 4 to 10, comprising a microprocessor (160) for performing the calculations to form the first, second and third neural networks, and the calculator, and memory areas (170a, 170b) for storing the data, these memory areas being accessible via the microprocessor (160) and including a memory area (170a) for storing the structure data of the neural networks, the fixed parameters and the synaptic coefficients of the second neural network, and a random access memory area (170b) for storing or producing the variable measurements, and the synaptic coefficients of the first and of the third neural networks.

12. A monitoring system as claimed in any one of claims 1 to 11, this system (100) being coupled to a rechargeable battery (110), to time measuring means (150a), voltage measuring means (150b), and display means (140) arranged for producing either an indication of the critical instant ($t_{TH}$) at which the battery will reach the critical voltage threshold ($Vt_{TH}$), or an indication of the lapse of time ($\Delta t_{TH}$) that is left from a current instant of use (t) onwards until the instant ($t_{TH}$) at which the battery will reach a predetermined critical voltage threshold ($Vt_{TH}$), or the two indications, and possibly an indication of the end of the recharge period of the battery.

13. A host device (130) fed by a rechargeable battery (110) and comprising a monitoring system (100) as claimed in claim 12, this host device being fed by the rechargeable battery (110) which is coupled to said monitoring system.

14. A method of producing neural networks of the monitoring system as claimed in any one of the claims 7 to 12, comprising in a learning period:

- the learning by the first neural network, of discharge time curves (t) as a function of the discharge voltage (Vt) during which discharge voltages (Vt) are imposed on the input of the first neural network normally intended for the voltage value, and the corresponding instants (t) are imposed on the output for forming a data base formed by vectors of the synaptic coefficients (WjA) of this first neural network,
- the learning by the second neural network of relations between the initial values (Vo, $\Delta$Vo, No) and the synaptic coefficients (WjA) of the first neural network, determined in its learning procedure,
- the learning of the third neural network to make it determine its own adaptive synaptic coefficients (WkC), this learning comprising the steps of:

1) in the discharge period (PD1) of a discharge/charge cycle of the battery, storing the initial values (Vo, $\Delta$Vo, No) and instantaneous real values of the battery voltage (Vt) as a function of the corresponding current instant (t), and approximate parameters (WjB) produced by the second neural network (NN2),
2) in the subsequent charge period (PC1), this learning comprising the sub-steps of:

2a) calculating by the first neural network its own real synaptic coefficients (WjA*) when the instantaneous voltage (Vt) and time (t) values are imposed on its input and on its output respectively,
2b) calculating error parameters (WjC*) by calculating the differences between the real parameters (WjA*) and the approximate parameters (WjB),
2c) calculating by the third neural network (NN3) its own synaptic coefficients (WkC) called adaptive parameters when the error parameters (WjC*) are imposed on its output and the initial values (Vo, $\Delta$Vo, No) are imposed on its inputs, and

a method of use of the monitoring system comprising the use of said adaptive parameters (WkC) as synaptic coefficients of the third neural network (NN3) in the later discharge period of the next discharge/charge cycle.

FIG.1A

FIG.1B

FIG.2A

FIG.2B

FIG. 2C

FIG.4C

FIG.3

FIG.4A

FIG.4B

FIG.5A

FIG.5B

FIG.6A

FIG.6B